(19) Europäisches Patentamt / European Patent Office / Office européen des brevets

(11) **EP 3 891 897 B1**

(12) **EUROPEAN PATENT SPECIFICATION**

(45) Date of publication and mention
of the grant of the patent:
**24.01.2024 Bulletin 2024/04**

(21) Application number: **19809529.1**

(22) Date of filing: **03.12.2019**

(51) International Patent Classification (IPC):
**H03M 13/11** *(2006.01)*

(52) Cooperative Patent Classification (CPC):
**H03M 13/1117; H03M 13/6577**

(86) International application number:
**PCT/EP2019/083544**

(87) International publication number:
**WO 2020/115070 (11.06.2020 Gazette 2020/24)**

(54) **ITERATIVE DECODER FOR DECODING A CODE COMPOSED OF AT LEAST TWO CONSTRAINT NODES**

QUANTISIERTER VORZEICHENBEWAHRENDER MIN-SUM DECODER FÜR LDPC CODES

DÉCODEUR MIN-SUM QUANTIFIÉ ET PRESERVANT LE SIGNE POUR CODES LDPC

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **03.12.2018 EP 18306599**

(43) Date of publication of application:
**13.10.2021 Bulletin 2021/41**

(73) Proprietor: **Universite De Bretagne Sud**
**56100 Lorient (FR)**

(72) Inventors:
• **COCHACHIN HENOSTROZA, Franklin**
**56100 LORIENT (FR)**
• **BOUTILLON, Emmanuel**
**56100 LORIENT (FR)**

(74) Representative: **Novagraaf Technologies**
**Bâtiment O2**
**2, rue Sarah Bernhardt**
**CS90017**
**92665 Asnières-sur-Seine Cedex (FR)**

(56) References cited:
• CUI Z ET AL: "Improved low-complexity low-density parity-check decoding", IET COMMUNICATIONS, vol. 2, no. 8, 3 September 2008 (2008-09-03), pages 1061-1068, XP006031512, ISSN: 1751-8636, DOI: 10.1049/IET-COM:20070570
• NGUYEN-LY THIEN TRUONG ET AL: "Non-surjective finite alphabet iterative decoders", 2016 IEEE INTERNATIONAL CONFERENCE ON COMMUNICATIONS (ICC), IEEE, 22 May 2016 (2016-05-22), pages 1-6, XP032922286, DOI: 10.1109/ICC.2016.7511111
• SHIVA KUMAR PLANJERY ET AL: "Finite Alphabet Iterative Decoders-Part I: Decoding Beyond Belief Propagation on the Binary Symmetric Channel", IEEE TRANSACTIONS ON COMMUNICATIONS., vol. 61, no. 10, 1 October 2013 (2013-10-01), pages 4033-4045, XP055581637, PISCATAWAY, NJ. USA. ISSN: 0090-6778, DOI: 10.1109/TCOMM.2013.090513.120443
• COCHACHIN F ET AL: "Optimization of Sign-Preserving Noise-Aided Min-Sum Decoders with Density Evolution", PROC., IEEE 10TH INTERNATIONAL SYMPOSIUM ON TURBO CODES & ITERATIVE INFORMATION PROCESSING (ISTC), IEEE, 3 December 2018 (2018-12-03), pages 1-5, XP033506498, DOI: 10.1109/ISTC.2018.8625309

EP 3 891 897 B1

## Description

### Technical Field

Various example embodiments relate to iterative decoding of a code composed of at least two constraint nodes, such as turbocodes or LDPC (Low Density Parity Check) codes.

### Background

During the past two decades, Turbocodes and Low Density Parity Check (LDPC) codes have emerged as a crucial component of many communication standards. These codes can offer performance close to the Shannon limit for error rates above the decoder's error floor.

Particularly, LDPC codes are widely used in communications standards like DVB-S2, DVB-S2X, IEEE 802.3, etc. LDPC codes can be efficiently decoded by Message-Passing (MP) algorithms that use a Tanner graph representation of the LDPC codes. The Belief-Propagation (BP) decoder has excellent decoding performance in the waterfall region but at a cost of a high computational complexity. The Min-Sum (MS) and Offset Min-Sum (OMS) decoders are simplified version of the BP that are much less complex but at a cost of a slight decoding performance degradation in the waterfall region. Reducing the bit-size representation of message is a technique that further reduces the complexity of the decoder, again, at a cost of performance loss.

In the last fifteen years, the quantization problem has been extensively studied over the Binary-Input Additive White Gaussian Noise (BI-AWGN) channel. From these works, it can be concluded that 6 bits of quantization gives almost optimal performance. It can also be observed that all paper on finite precision use the "no-decision value", i.e., a Log-Likelihood Ratio (LLR) equal to 0 (without defined sign, thus) in their messages representation. This is also true for the recent work on Non-surjective Finite Alphabet Iterative Decoders (NS-FAIDs) which provides a unified framework for several MS-based decoders like Normalized MS (NMS), OMS, Partially OMS.

In "Improved low-complexity low-density parity-check decoding", Cuiz et al., a weighted bit-flipping (WBF) algorithm is proposed called improved modified WBF (IMWBF). The IMWBF uses the bit of sign plus an extra bit to give a weight to the message, thus, exchange messages are on two bits. However, like all Bit Flipping algorithm, the same message it broadcasted by a given variable node to its associated check nodes.

In "Non-surjective finite alphabet iterative decoders", Nguyen-Ly Thien Truong et al. and "Finite alphabet Iterative Decoders-Part I: Decoding Beyond Belief Propagation on the Binary Symmetric Channel", Shiva Kumar Planjery et al., the authors propose an algorithm named Non-Surjective Finite Alphabet Iterative Decoder (NS-FAID). A characteristic of this algorithm is that the 0 value is encoded in all the messages it exchanges.

### Summary

However, from all these work, it appears there is still a need for a decoder having good performance with a relative low complexity, i.e. a decoder which works well with few quantization bits. The invention is set out in the appended set of claims.

### Brief Description of the Figures

Some embodiments are now described, by way of example only, and with reference to the accompagnying drawings, in which :

- The Figure 1 schematically illustrates an iterative decoder;
- The Figure 2 illustrates a flow chart of an iterative decoding method;
- The Figure 3 schematically illustrate a mapping used for the noise model Y;
- The Figure 4 illustrates the FER performance of MS and SP-MS decoders for (3, 6)-regular LDPC code;
- The Figure 5 illustrates the FER performance of MS and SP-MS decoders for (4, 8)-regular LDPC code;
- The Figure 6 illustrates the FER performance of MS and SP-MS decoders for (5, 10)-regular LDPC code;
- The Figure 7 illustrates the FER performance of MS and SP-MS decoders for the IEEE 802.3 ETHERNET code;
- The Figure 8 illustrates the FER performance of MS and SP-MS decoders for the WIMAX rate ½ LDPC code;
- The Figure 9 illustrates the FER performance of MS and SP-MS decoders for the WIMAX rate ¾ B LDPC code;
- The Figure 10 illustrates the FER convergence comparison on (5, 10)-regular LDPC code at $E_b/N_0$ = 3.75dB;

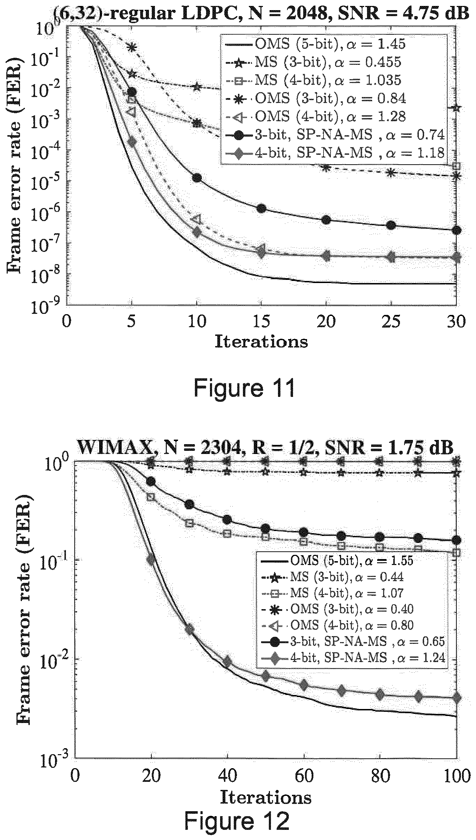

- The Figure 11 illustrates the FER convergence comparison on the IEEE 802.3 ETHERNET code at $E_b/N_0$ = 4.75dB;
- The Figure 12 illustrates the FER convergence comparison on the WIMAX rate ½ LDPC code at $E_b/N_0$ = 1.75dB; and
- The Figure 13 illustrates the FER performance of MS and SP-MS decoders for the IEEE 802.3 ETHERNET code with various alphabet lengths.

- The Figure 14 illustrates the performances of the SP-MS decoder in comparison with other decoders.

## Description of Embodiments

As a preliminary remark, the following described embodiments are focused on LDPC codes. However, the man skilled in the art may transpose without particular difficulties, the teaching to a code having at least two constraint nodes, particularly turbocodes. In the latter case, the constraint nodes use convolution as predetermined rule.

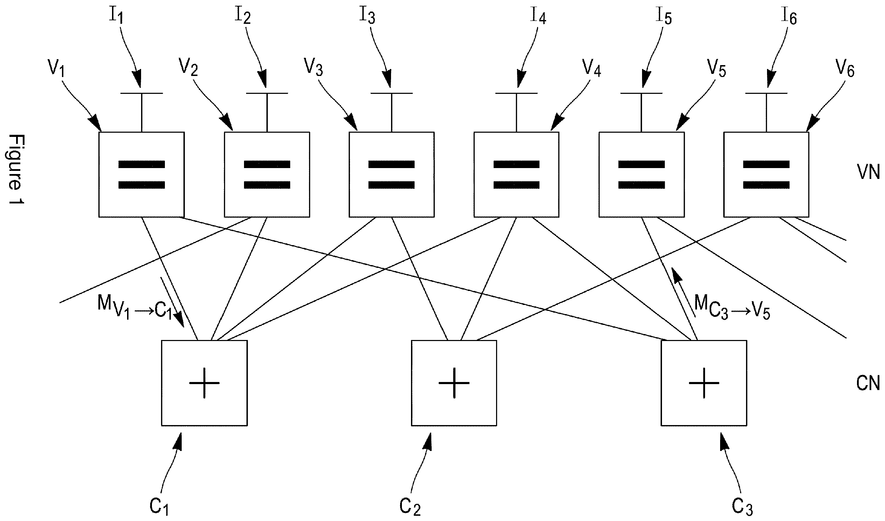

In reference to FIG. 1, an iterative decoder 1 is configured for decoding LDPC codes having a codeword length N. It means that the message was coded on N bits.

In the illustrated example, N = 6. However, in practice, the codeword length N is much larger and can be typically around 64 000.

The decoder 1 comprises N variable nodes (VNs) $v_n$, n = 1...N. It means that the variable node $v_n$ receives the result $I_n$ of the signal quantization for the bit n of the received message. The signal quantization will not be described further as it is a step well known from the man skilled in the art.

The result $I_n$ is a combination of the estimated value, either 0 or 1, and a likelihood that this estimated value is the correct one expressed as a log-likelihood ratio LLR. $I_n$ is defined on a alphabet $A_L$ of $q_{ch}$ quantization bits, $q_{ch}$ being an integer equal or greater than 3.

$I_n$ is coded on a particular alphabet $A_L$, or representation, called Sign-Magnitude. The alphabet is symmetric around zero. $A_L = \{-N_{qch},..., -1, -0, +0, +1, ...,+N_{qch}\}$ in which the sign indicates the estimated bit value and the magnitude represents its likelihood.

The following table gives the representation on 3 bits for a classical decoder using a 2-Complement representation and for the described decoder 1 using a Sign-Magnitude representation

| Estimated value | Likelihood | 2-Complement | Sign-Magnitude |
|---|---|---|---|
| 1 | 3 | 101 | 111 |
| 1 | 2 | 110 | 110 |
| 1 | 1 | 111 | 101 |
| 1 | 0 | 000 | 100 |
| 0 | 0 | | 000 |
| 0 | 1 | 001 | 001 |
| 0 | 2 | 010 | 010 |
| 0 | 3 | 011 | 011 |

The variable nodes VNs use for all their computation an alphabet $A_s$ constructed similarly than the alphabet $A_L$ but with q quantization bits, $q \leq q_{ch}$.

The decoder 1 comprises also M constraint nodes CNs $c_m$, m = 1...M, $2 \leq M < N$.

The variable nodes VNs and the constraint nodes CNs are the nodes of a Tanner graph. The edges of the Tanner graph defines the relationship between variable nodes and constraint nodes along which they exchange messages.

The message sends by variable node $v_n$ to constraint node $c_m$ at iteration $\ell$ is named $m_{v_n \to c_m}^{(\ell)}$ and the

message sends by constraint node $c_m$ to variable node $v_n$ at iteration $\ell$ is named $m_{c_m \to v_n}^{(\ell)}$.

The set of constraint nodes connected in the Tanner graph to the variable node $v_n$ is named $V(v_n)$. The degree $d_v$ of the variable node $v_n$ is defined as the size of the set $V_{(vn)}$, i.e. the number of constraint nodes connected to the variable node. And $V_{(vn)\backslash\{cm\}}$ is defined as the set $V_{(vn)}$ except the constraint node $c_m$.

Each variable node $v_n$ estimates the value $y_n$ of the nth bit of the codeword to be decoded and send messages

$m_{v_n \to c_m}^{(\ell)}$, messages belonging to $A_s$, to the connected constraint nodes $c_m$.

At the first iteration, each variable node $v_n$ sends to its connected constraint nodes the value $I_n$.

At each iteration $\ell$, $\ell > 1$, each variable node $v_n$ computes sign-preserving factors $\mu_{v_n \to c_m}^{(\ell)}$ which are the sum of the ponderated sign of LLR $l_n$ and the sum of the signs of all messages, except for the message coming from $c_m$, received from the connected constraint nodes.

$$\mu_{v_n \to c_m}^{(\ell)} = \xi \times sign\,(l_n) + \sum_{c \in V(v_n) \backslash \{c_m\}} sign\left(m_{c \to v_n}^{(\ell)}\right) \quad (1)$$

where $\xi$ is a positive or a null integer.

$\xi$ is equal to 0 if $d_v = 2$, equal to 1 if $d_v > 2$ and $d_v$ is odd, and equal to 2 if $d_v > 2$ and $d_v$ is even.

Then the variable node $v_n$ compute the messages to send to the constraint nodes $c_m$ for iteration $\ell + 1$ in two steps.

$$m_{v_n \to c_m}^{(\ell+1),U} = l_n + \frac{1}{2} \times \mu_{v_n \to c_m}^{(\ell)} + \sum_{c \in V(v_n) \backslash \{c_m\}} \left(m_{c \to v_n}^{(\ell)}\right) \quad (2)$$

and

$$m_{v_n \to c_m}^{(\ell+1)} = \left( sign\left(m_{v_n \to c_m}^{(\ell+1),U}\right), \mathcal{S}\left(floor\left(abs\left(m_{v_n \to c_m}^{(\ell+1),U}\right)\right)\right)\right) \quad (3)$$

where S is a function from the set of value that can take $floor\left(abs\left(m_{v_n \to c_m}^{(\ell+1),U}\right)\right)$ to the set $A_s$.

Each constraint node $c_m$ tests the received message contents with predetermined constraints. The constraints may be parity check, convolution code or any block code. Typically for LDPC code, the constraint is parity check and the constraint nodes are thus named check nodes.

After analyzing the constraints, each constraint nodes $c_m$ sends messages $m_{c_m \to v_n}^{(\ell)}$ to the connected variable nodes $v_n$.

The messages $m_{c_m \to v_n}^{(\ell)}$ belongs to an alphabet $A_c$. Alphabet $A_c$ uses also a Sign-Magnitude representation but with a set of value similar or different than $A_s$. The alphabet $A_s$ and $A_c$ are thus symmetric around zero as $AL$.

Alphabet Ac may use a Sign-Magnitude representation with a set of value similar or different than As in terms or cardinality, i.e. Ac could be equal to {-3,-2,-1,-0,+0,+1,+2,+3} while As can be equal to {-1,-0, +0,+1} for example. By "similar", one should understand equal or approximatively equal.

In a particular embodiment, the function S may be defined as S(x) = min(max( x - λ(x), 0),+Nq), where λ(x) is an integer offset value depending on the value of x. More particularly, λ(x) is a random variable that can take its value in a predefined set of values according to a predefined law. A careful choice of the offset value will allow a smooth convergence of the iterative process by decreasing the impact of high likelihood during propagation.

The message emissions are repeated until the decoding of the codeword is achieved successfully or a predetermined number of iteration is reached.

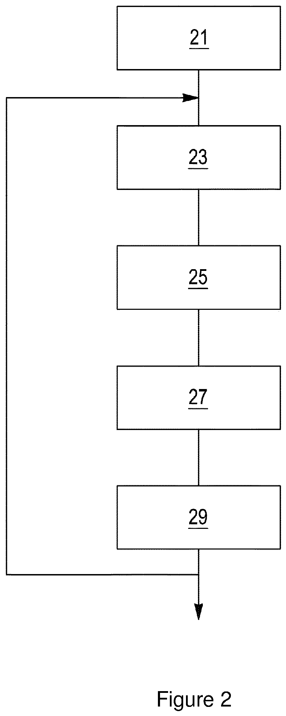

Consequently, the method for decoding is the following, Figure 2:

- Reception and storage of the LLR $l_n$ by the variable node $v_n$, n = 1...N, step 21;
- Emission of messages $m_{v_n \to c_m}^{(1)}$ , step 23;
- Verification of the constraints by the constraint nodes $c_m$, step 25;
- Emission of messages $m_{c_m \to v_n}^{(1)}$ containing a possible candidate value for the variable n solving the constraints, step 27 ;
- Computation by the variable nodes of equations (1), (2) and (3), step 29;
- Iteration of steps 23 to 29 until the codeword is decoded or the number of iteration reaches a predetermined count.

In the following sections, a comparison of classical quantized decoders with the disclosed decoder, which will be called Sign-Preserving Min-Sum (SP-MS) decoder, will be exposed as well as some theorical analysis and modelisation showing the improvements of the disclosed decoder. Finally, some experimental results will be disclosed.

**Basic Notions of Classical Quantized Decoders and LDPC Codes**

An LDPC code is a linear block code defined by a sparse parity-check matrix $H = [h_{mn}]$ of M rows by $N$ columns, with $M < N$. The usual graphical representation of an LDPC code is made by a Tanner graph which is a bipartite graph $G$ composed of two types of nodes, the variable nodes (VNs) $v_n, n = 1...N$ and the check nodes (CNs) $c_m$, $m = 1...M$. A VN in the Tanner graph corresponds to a column of $H$ and a CN corresponds to a row of $H$, with an edge connecting CN $c_m$ to VN $v_n$ exists if and only if $h_{mn} \neq 0$.

Let us assume that $v$ is any VN and $c$ is any CN. Let us also denote $V(v)$ the set of neighbors of a VN $v$, and denote $V(c)$ the set of neighbors of a CN $c$. The degree of a node is the number of its neighbors in G. A code is said to have a regular column-weight $d_v = |V(v)|$ if all VNs $v$ have the same degree $d_v$. Similarly, if all CNs $c$ have the same degree $d_c = |V(c)|$, a code is said to have a regular row-weight $d_c$. In case of irregular LDPC codes, the nodes can have different connexion degrees, defining an irregularity distribution, which is usually characterized by the two polynomials

$\lambda(x) = \dfrac{\sum_{i=2}^{d_{v,max}} \lambda_i x^{i-1}}{}$ , and $\rho(x) = \sum_{j=2}^{d_{c,max}} \rho_j x^{j-1}$ . The parameters $\lambda_i$ (respectively $\rho_j$) indicate the fraction of edges connected to degree $i$ VNs (respectively degree j CNs). For regular codes, the polynomials reduce to monomials, $\lambda(x) = x^{d_v-1}$ and $\rho(x) = x^{d_c-1}$.

Let $\mathbf{x} = (x_1,...,x_N) \in \{0,1\}^N$ denote a codeword which satisfies $Hx^T = 0$. In the following examples, $\mathbf{x}$ is mapped by the Binary Phase-Shift Keying (BPSK) modulation and transmitted over the BI-AWGN channel with noise variance $\sigma^2$. The channel output $\mathbf{y} = (y_1,...,y_N)$ is modeled by $y_n = (1 - 2x_n) + z_n$ for $n = 1, ..., N$, where $z_n$ is a sequence of independent and identically distributed (i.i.d.) Gaussian random variables with zero mean and variance $\sigma^2$. The decoder produces the vector $\hat{x} = (\hat{x}_1,...,\hat{x}_N) \in \{0,1\}^N$ which is an estimation of x. To check if $\hat{x}$ is a valid codeword, we verify that the syndrome vector is all-zero, i.e. $H\hat{x}^T = 0$.

For classical quantized decoders the finite message alphabet $\mathcal{A}_C$ is defined as

$$\mathcal{A}_C = \{-N_q,\ldots,-1,0,+1,\ldots,+N_q\}$$

and consists of $N_s = 2N_q + 1$ states, with $N_q = 2^{(q-1)} - 1$ where $q$ is the number of quantization bits. Let us denote $A_L$ the decoder input alphabet, and denote $\ell \in \mathbb{N}$ the iteration number. Let us also denote

$$m_{v \to c}^{(\ell)} \in \mathcal{A}_C .$$

the message sent from VN v to CN c in the $\ell^{th}$ iteration, and denote

$$m_{c \to v}^{(\ell)} \in \mathcal{A}_C .$$

the message sent from CN c to VN v in the $\ell^{th}$ iteration.

The LLR that can be computed at the channel output is equal to:

$$LLR(y_n) = log\left(\frac{Pr\,(y_n|x_n=0)}{Pr\,(y_n|x_n=1)}\right) = \frac{2y_n}{\sigma^2}. \qquad (11)$$

We assume that

$$\mathcal{A}_C = A_L,$$

hence, *LLR(y$_n$)* has to be quantized and saturated. For classical decoders, let us denote the quantizer by $Q: \mathbb{R} \to A_L$, defined as

$$Q(a) = \mathcal{S}\big(\lfloor \alpha \times a + 0.5 \rfloor, N_q\big), \qquad (12)$$

where $\lfloor \; \rfloor$ depicts the floor function and

$$\mathcal{S}(b, N_q)$$

is the saturation function clipping the value of b in the interval [-$N_q$,$N_q$], i.e.

$$\mathcal{S}(b, N_q) =$$

*min (max (b, -N$_q$), +N$_q$)*. The parameter $\alpha$ is called channel gain factor and is used to enlarge or decrease the standard deviation of quantized values at the decoder input. The value of $\alpha$ can be seen as an extra degree of freedom in the quantized decoder definition that can be analyzed and optimized for quantized decoders on the BI-AWGN channel. Note that if a is too large most of quantized values will be saturated to $N_q$. With those notations, we define the quantized version of the intrinsic LLR that initialize the classical decoder by the vector

$$\mathbf{I} = (I_1, \dots, I_N) \in \mathcal{A}_C^N,$$

with

$$I_n = Q(LLR(y_n)) \quad \forall n = 1, \dots, N \tag{13}$$

A MP decoder exchanges messages between VNs and CNs along edges using a Tanner graph. During each iteration, the VN update (VNU) and CN update (CNU) compute outgoing messages from all incoming messages.

Let us briefly recall the VNU and CNU equations for the Min-Sum based decoders, before introducing the Sign-Preserving Min-Sum (SP-MS) decoders. For this purpose, we define the discrete update functions for quantized Min-Sum based decoders. Let

$$\Psi_v: A_L \times \mathcal{A}_C^{(d_v-1)} \to \mathcal{A}_C,$$

denote the discrete function used for the update at a VN *v* of degree *d$_v$*. Let

$$\Psi_c: \mathcal{A}_C^{(d_c-1)} \to \mathcal{A}_C,$$

denote the discrete function used for the update at a CN *c* of degree *d$_c$*.

Thus the update rule at a CNU is given by

$$m_{c_m \to v_n}^{(\ell)} = \Psi_c\left(\left\{m_{v \to c_m}^{(\ell)}\right\}_{v \in V(c_m)\backslash\{v_n\}}\right) =$$

$$\left(\prod_{v \in V(c_m)\backslash\{v_n\}} sign\left(m_{v \to c_m}^{(\ell)}\right)\right)\left(\min_{v \in V(c_m)\backslash\{v_n\}}\left(\left|m_{v \to c_m}^{(\ell)}\right|\right)\right). \quad (14)$$

And the update rule at a VNU is expressed as

$$m_{v_n \to c_m}^{(\ell+1)} = \Psi_v\left(I_n, \left\{m_{c \to v_n}^{(\ell)}\right\}_{c \in V(v_n)\backslash\{c_m\}}\right) = \Lambda\left(m_{v_n \to c_m}^{(\ell+1),U}\right), \quad (15)$$

where the function A(.) and the unsaturated v-to-c message $m_{v_n \to c_m}^{(\ell+1),U}$ are defined by

$$\Lambda(a) = sign(a) \times S\left(max\left(|a| - \lambda_v, 0\right), N_q\right).$$

$$m_{v_n \to c_m}^{(\ell+1),U} = I_n + \sum_{c \in V(v_n)\backslash\{c_m\}} m_{c \to v_n}^{(\ell)}.$$

The alphabet of $m_{v_n \to c_m}^{(\ell+1),U}$, denoted $\mathcal{A}_U$, is defined as

$$\mathcal{A}_U = \{-N_q \times$$

$d_v,...,-1,0,+1,...,+N_q \times d_v\}$. We define the classical OMS decoder with offset value $\lambda_v \in \{+1,...,+(N_q - 2)\}$, where the special case of $\lambda_v = 0$ corresponds to the classical MS decoder. It must be noted that the discrete functions $\Psi_v$ and $\Psi_c$ satisfy the symmetry conditions.

Now, let us further $\gamma^{(\ell)} = (\gamma_1^{(\ell)},...,\gamma_N^{(\ell)})$ denote the a posteriori probability (APP) in the $\ell^{th}$ iteration. Let us also denote $\mathcal{A}_{app}$ the alphabet of APPs with

$$\mathcal{A}_{app} = \{-N_q \times (d_v + 1),...,-1,0,+1,...,+N_q \times (d_v + 1)\}.$$

The APP

$$\gamma_n^{(\ell)} \in \mathcal{A}_{app}$$

is associated to a VN $v_n$, $n = 1,2, ..., N$. The APP update at a VN $v_n$ of classical MS-based decoders is given by

$$\gamma_n^{(\ell)} = \Psi_v\left(I_n, \left\{m_{c \to v_n}^{(\ell)}\right\}_{c \in V(v_n)}\right) = I_n + \sum_{c \in V(v_n)} m_{c \to v_n}^{(\ell)}. \quad (16)$$

From the APP, $\hat{x}_n$ can be computed as $\hat{x}_n = (1 - sign(\gamma_n^{(\ell)}))/2$ if $\gamma_n^{(\ell)} \neq 0$, otherwise, $\hat{x}_n = 0$ if $I_n > 0$ and $\hat{x}_n = 1$ if $I_n \leq 0$, for n = 1,...,N.

We must take into account that at the initialization of MP decoders, variable-to-check messages $m_{v_n \to c_m}^{(\ell)}$ are initialized by $I_n$ at $\ell = 0$, i.e. $m_{v_n \to c_m}^{(0)} = I_n$ where $v_n \in V(c_m)$.

**Sign-Preserving Min-Sum (SP-MS) Decoders**

In the classical MS-based decoders, the value of the v-to-c message can be zero, see (5). In that case, the erased message, *i.e.* $m_{v_n \to c_m}^{(\ell+1)} = 0$, does not carry any information and does not participate in the convergence of the decoder. In this paper, we propose a new type of decoder, with a modified VNU using a *sign preserving factor,* which never propagates erased messages.

Quantization used for SP-MS Decoders

Using the sign-and-magnitude representation one can obtain a message alphabet which is symmetric around zero and which is composed of $N_s = 2^q$ states. Hence the message alphabet for SP-MS decoders denoted by $\mathcal{A}_S$ is defined as

$$\mathcal{A}_S = \{-N_q, \ldots, -1, -0, +0, +1, \ldots, +N_q\}.$$

The sign of a message

$$m \in \mathcal{A}_S$$

indicates the estimated bit value associated with the VN to or from which m is being passed while the magnitude |m| of m represents its reliability. In this paper, it is assumed that

$$\mathcal{A}_L = A_S.$$

An example of the binary representation of $\mathcal{A}_C$ and $\mathcal{A}_S$ for $q = 3$ is shown in Table 1, one can see that -0 is represented by $100_2$, +0 is represented by $000_2$, etc.

Table 1: Binary representation of the quantized values.

| Classical Decoder | | Sign Preserving Decoder | | |
|---|---|---|---|---|
| $m \in A_C$ | $q$ = 3 bits | $m \in A_S$ | $q$ = 3 bits | ( *sign* (m), \|m\|) |
| -3 | 101 | -3 | 111 | (-1,3) |
| -2 | 110 | -2 | 110 | (-1,2) |
| -1 | 111 | -1 | 101 | (-1,1) |
| - | 100 | -0 | 100 | (-1,0) |

(continued)

| Classical Decoder | | Sign Preserving Decoder | | |
|---|---|---|---|---|
| $m \in A_C$ | $q$ = 3 bits | $m \in A_S$ | $q$ = 3 bits | ( $sign$ $(m)$, $|m|$) |
| 0 | 000 | +0 | 000 | (+1,0) |
| +1 | 001 | +1 | 001 | (+1,1) |
| +2 | 010 | +2 | 010 | (+1,2) |
| +3 | 011 | +3 | 011 | (+1,3) |

The quantization process defined in (12) is replaced by

$$Q^*(a) = \Big(\text{sign}(a), \mathcal{S}\big(\lceil \alpha \times |a| \rceil - 1, N_q\big)\Big), \qquad (17)$$

where $\lceil \ \rceil$ depicts the ceiling function. The quantized LLR is thus defined as

$$I_n = Q^*(LLR(y_n)) \in \mathcal{A}_S$$

for $n$ = 1,...,$N$. Let us define the update rules for Sign-Preserving decoders.

Sign-Preserving Min-Sum Decoders

One can note from (14) that the CNU by construction determines the sign of each outgoing message, thus the CNU generates outgoing messages that always belong to $\mathcal{A}_S$, therefore, the CNU remains identical. In the case of the VNU, (15) should be modified to ensure that the outgoing message will always belong to $\mathcal{A}_S$. To preserve always the sign of the messages, let us denote by $\mu_{v_n \to c_m}^{(\ell)}$ the *sign-preserving factor* of the message $m_{v_n \to c_m}^{(\ell+1)}$, defined as

$$\mu_{v_n \to c_m}^{(\ell)} = \xi \times sign(I_n) + \sum_{c \in V(v_n) \backslash \{c_m\}} sign\big(m_{c \to v_n}^{(\ell)}\big), \qquad (18)$$

where the values of $\xi$ depends on the value of the column-weight $d_v$ of a VN $v_n$, thus we have

$$\xi = \begin{cases} 0, & if & d_v = 2, \\ 1, & if & d_v > 2 \ and \ (d_v \bmod 2) = 1, \\ 2, & if & d_v > 2 \ and \ (d_v \bmod 2) = 0. \end{cases} \qquad (19)$$

Note that the other values of $\xi$ give worse decoding performance.

From (18), one can note that, by construction, $\mu_{v_n \to c_m}^{(\ell)}$ is the sum of $d_v$ (resp. $d_v$ + 1) values in {-1, +1} if $d_v$ is odd (resp. if $d_v$ is even and greater than 2), and $\mu_{v_n \to c_m}^{(\ell)} \in \{-1, +1\}$ for the special case of $d_v = 2$. Thus, $\mu_{v_n \to c_m}^{(\ell)}$ is always an odd number.

The update rule of the Sign-Preserving Offset Min-Sum (SP-OMS) VNU is changed from (5) to

$$m_{v_n \to c_m}^{(\ell+1)} = \Psi_v \left( I_n, \left\{ m_{c \to v_n}^{(\ell)} \right\}_{c \in V(v_n)\setminus\{c_m\}} \right) =$$

$$\left( sign \left( m_{v_n \to c_m}^{(\ell+1),U} \right), \mathcal{S} \left( max \left( \left| m_{v_n \to c_m}^{(\ell+1),U} \right| - \lambda_v, 0 \right), N_q \right) \right), \qquad (20)$$

where $m_{v_n \to c_m}^{(\ell+1),U}$ is the unsaturated v-to-c message of Sign-Preserving decoders, given by

$$m_{v_n \to c_m}^{(\ell+1),U} = \Lambda^* \left( \frac{\mu_{v_n \to c_m}^{(\ell)}}{2} + I_n + \sum_{c \in V(v_n)\setminus\{c_m\}} m_{c \to v_n}^{(\ell)} \right),$$

the function A*(.) is defined by $\Lambda^*(a) = ( sign\,(a), \lfloor |a| \rfloor )$. Note that A*(.) is applied on a non-null value since by construction, the fractional part of $(\mu_{v_n \to c_m}^{(\ell)})/2$ is 0.5.

We define a Sign-Preserving Min-Sum (SP-MS) decoder by setting $\lambda_v = 0$. For Sign-Preserving decoders, we have

$$\mathcal{A}_U = \{ -N_q \times d_v -$$

$$\lfloor d_v/2 \rfloor), \dots, -1, -0, +0, +1, \dots, +N_q \times d_v + \lfloor d_v/2 \rfloor \}.$$

The APP update at a VN $v_n$ of Sign-Preserving decoders is given by

$$\gamma_n^{(\ell)} = \Psi_v \left( I_n, \left\{ m_{c \to v_n}^{(\ell)} \right\}_{c \in V(v_n)} \right) = I_n + \frac{1}{2} \times \xi \times sign\,(I_n) +$$

$$\sum_{c \in V(v_n)} \left( m_{c \to v_n}^{(\ell)} + \frac{1}{2} \times sign \left( m_{c \to v_n}^{(\ell)} \right) \right). \qquad (21)$$

The alphabet of APPs for Sign-Preserving decoders is given by $\mathcal{A}_{app} = \{ -(N_q \times (d_v + 1) + (d_v + \xi)/2), \dots, -1, 0, +1, \dots, +(N_q \times (d_v + 1) + (d_v + \xi)/2) \}$. From the APP, $\hat{x}_n$ can be computed as $\hat{x}_n = sign(I_n)$ if $\gamma_n^{(\ell)} = 0$, otherwise,

$\hat{x}_n = sign(\gamma_n^{(\ell)})$ for n = 1, ...,N.

### Sign-Preserving Noise-Aided Min-Sum Decoders

In order to define the noisy version of the SP-MS decoder, named Sign-Preserving Noise-Aided Min-Sum (SP-NA-MS) decoder, we first introduce the constraints on the noise models, and then we present a noise model that we use to perturb noiseless decoders.

### 1. Probabilistic Error Model for SP-NA-MS Decoders

We assume that the noisy message alphabet is denoted by $\tilde{\mathcal{A}}_S$. The noisy message $\tilde{m}_{v_n \to c_m}^{(\ell+1)}$ is obtained

after corrupting the noiseless message $m_{v_n \to c_m}^{(\ell+1),U}$ with noise. To simplify the notations is this section, we use $m_u$ to denote any $m_{v_n \to c_m}^{(\ell+1),U}$ and $\tilde{m}$ to denote any $\tilde{m}_{v_n \to c_m}^{(\ell+1)}$.

DE analysis of SP-NA-MS decoders can be performed only using memoryless noise models which must satisfy the following condition of symmetry

$$\Pr(\tilde{m} = \psi_2 | m_u = \psi_1) = \Pr(\tilde{m} = -\psi_2 | m_u = -\psi_1), \forall \psi_1 \in \mathcal{A}_U \; and$$

$$\psi_2 \in \tilde{\mathcal{A}}_S.$$

This noise model injects some randomness at the VNU of SP-NA-MS decoders. Thus the noisy-VNU is symmetric, allowing to use the all-zero codeword assumption necessary in DE. Since the addition of noise in VNUs is independent of the sign of the messages, we will suppose in the sequel without loss of generality that the messages $m_u$ and $\tilde{m}$ are always positive.

Now, let us denote

$$\Upsilon : \mathcal{A}_U \to \tilde{\mathcal{A}}_S \;|$$

the function which transforms

$$m_u \in \mathcal{A}_U$$

into

$$\tilde{m} = \Upsilon(m_u) \in \tilde{\mathcal{A}}_S$$

with the random process defined by the conditional probability density function (CPDF) $\Pr(\tilde{m}|m_u)$. In this document, the CPDF $\Pr(\tilde{m}|m_u)$ for the noise model Y is given by

$$Pr\left(\tilde{m}|m_u\right) =$$

$$\begin{cases} 1, & if \; \tilde{m} = m_u = +0 \; or \; if \; \tilde{m} = +N_q, m_u > +N_q, \\ \varphi(m_u), & if \; \tilde{m} = m_u - 1, \forall m_u \in \{+1, +2, \dots, +N_q\}, \\ 1 - \varphi(m_u), & if \; \tilde{m} = m_u, \forall m_u \in \{+1, +2, \dots, +N_q\}, \\ 0, & otherwise \, . \end{cases} \quad (22)$$

where $\varphi(m_u)$ is defined as

$$\varphi(m_u) = \begin{cases} \varphi_0, & if \; m_u = +N_q, \\ \varphi_a, & if \; m_u \in \{+2, \dots, +(N_q - 1)\}, \\ \varphi_s, & if \; m_u = +1, \end{cases} \quad (23)$$

The noise model analyzed is parametrized by three different transition probabilities $\varphi = (\varphi_s, \varphi_a, \varphi_0)$. The choice

of these three transition probabilities is a compromise between complexity and the process of the border effects in $\mathcal{A}_S$.

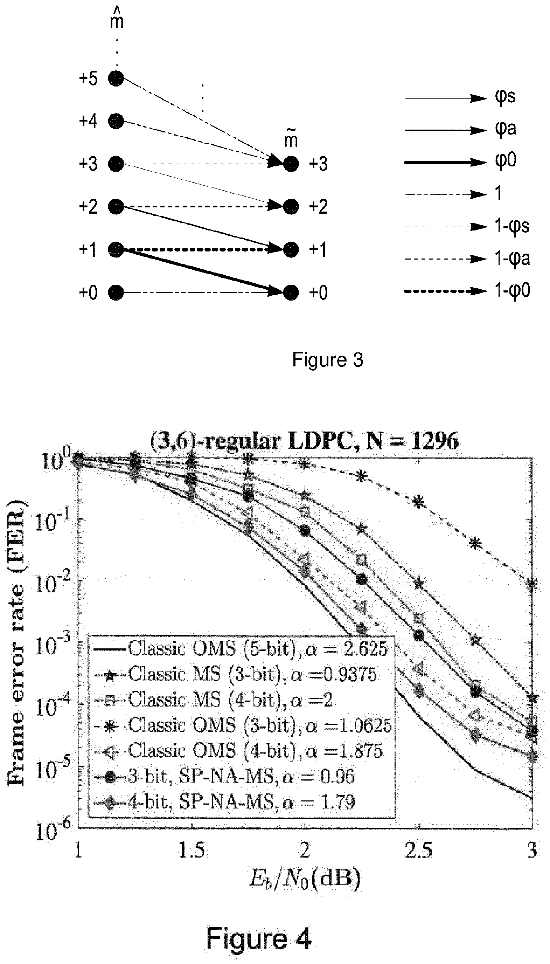

The reasoning behind Y is to implement a probabilistic offset with the purpose of always keeping the sign of the messages. With $\varphi = (\varphi_a, \varphi_a, \varphi_a)$, we can implement the SP-MS decoder setting $\varphi_a = 0$ and the SP-OMS with $\lambda_v = 1$ setting $\varphi_a = 1$. The effect of the noise on the extreme values of the message alphabet $\mathcal{A}_S$ is studied with $\varphi_s$ and $\varphi_0$. Thanks to Y, we can implement a SP-NA-MS decoder whose behaviour is a probabilistic weighted combination of a SP-MS decoder and a SP-OMS decoder. As an example, Y is depicted in Fig. 3 for ($q = 3$, $N_q = 3$).

2. Sign-Preserving Noise-Aided Min-Sum Decoders

A SP-NA-MS decoder is defined by injecting some randomness during the VNU processing. The SP-NA-MS decoder is implemented perturbing unsaturated v-to-c messages $m_{v_n \to c_m}^{(\ell+1),U}$ with noise. Hence, the update rule for a noisy-VNU is given by

$$\tilde{m}_{v_n \to c_m}^{(\ell+1)} = \Upsilon\left(m_{v_n \to c_m}^{(\ell+1),U}\right), \quad (24)$$

We can note that Y is a symmetric function that performs the saturation function.

Density Evolution for Sign-Preserving Decoders

The goal of DE is to recursively compute the probability mass function (PMF) of the exchanged messages in the Tanner graph along the iterations. DE allows us to predict if an ensemble of LDPC codes, parametrized by its degree distribution, decoded with a given MP decoder, converges to zero error probability in the limit of infinite block length.
In order to derive the DE equations for Sing-Preserving decoders, let $\theta^{(\ell)}(k)$,

$$k \in \mathcal{A}_S,$$

denote the PMF of noiseless c-to-v messages in the $\ell^{th}$ iteration. Similarly, let $\Omega^{(\ell)}(k)$,

$$k \in \mathcal{A}_S,$$

denote the PMF of noiseless v-to-c messages in the $\ell^{th}$ iteration. Also, let $\Omega^{(0)}(k)$, $k \in A_L$, be the initial PMF of messages sent at $\ell = 0$. To deduce the noisy DE equations, let $\tilde{\Omega}^{(\ell)}(k)$, $k \in \mathcal{A}_S$, denote the PMF of noisy v-to-c messages in the $\ell^{th}$ iteration. We consider that the all-zero codeword is sent over the BI-AWGN channel.

Initialization

DE is initialized with the PMF of the BI-AWGN channel with noise variance $\sigma^2$ as follows

$$p_{vtoc}^{(0)}(k) = \begin{cases} F(k) & if & k = -N_q \\ F(k) - F(k-1) & if & -N_q < k \le -1 \\ F(0) - F(-1) & if & k = -0 \\ F(1) - F(0) & if & k = +0 \\ F(k+1) - F(k) & if & +1 \le k < +N_q \\ 1 - F(k) & if & k = +N_q \end{cases} \qquad (25)$$

where $F(k) = \frac{1}{\sqrt{2\pi}\sigma_n} \int_{-\infty}^{k} e^{-(t-\mu_n)^2/2\sigma_n^2} fsimi$

$dt,$     (26)

with

$$\sigma_n = (2/\sigma) \times \alpha \text{ and } \mu_n = (2/\sigma^2) \times \alpha.$$

DE update for CNU

The input of a CNU is the PMF of the noisy messages going out of a noisy VNU, *i.e.* $\tilde{\Omega}^{(\ell)}$. For a CN of degree $d_c$, $\Theta_{d_c}^{(\ell)}$ is given by

$$\Theta_{d_c}^{(\ell)}(k) = \sum_{(i_1,...,i_{d_c-1}):\Psi_c(i_1,...,i_{d_c-1})=k} \tilde{\Omega}^{(\ell)}(i_1) ... \tilde{\Omega}^{(\ell)}(i_{d_c-1}), \quad 0.1cm \forall k \in \mathcal{A}_S.$$

(27)

Considering the diffe-rent connection degrees of CNs of irregular LDPC codes, we have

$$\Theta^{(\ell)}(k) = \sum_{d_c=2}^{d_{c,max}} \rho_{d_c} \times \Theta_{d_c}^{(\ell)}(k), \quad 0.3cm \forall k \in \mathcal{A}_S \qquad (28)$$

DE update for VNU

We know that Y perturbs unsaturated values. For this reason, we first compute the PMF of unsaturated v-to-c messages of a VN of degree $d_v$, *i.e.* $\Omega_{d_v}^{(\ell+1),U}$, with the following equation

$$\Omega_{d_v}^{(\ell+1),U}(k) =$$

$$\sum_{(t,i_1,...,i_{d_v-1}):\Psi_v(t,i_1,...,i_{d_v-1})=k} \Omega^{(0)}(t)\Theta^{(\ell)}(i_1)...\Theta^{(\ell)}(i_{d_v-1}), \quad 0.1cm \forall k \in \mathcal{A}_U.$$

(29)

And second, the noise effect is added to the PMF of unsaturated v-to-c messages to obtain the corrupted PMF

$$\widetilde{\Omega}_{d_v}^{(\ell+1)}(k) = \sum_{i \in \mathcal{A}_U} \Omega_{d_v}^{(\ell+1),U}(i) \times p_\Upsilon(i,k), \quad 0.1cm \forall k \in \mathcal{A}_S, \qquad (30)$$

where $p_\Upsilon$ is the transition probability of the VN noise, $p_\Upsilon$ also performs the saturation effect.

In this document, we use only the transition probabilities of the noise model Y defined here above. Although of course other noise models can be used.

Then the effect of the different connection degrees of VNs is considered using the following relation

$$\widetilde{\Omega}^{(\ell+1)}(k) = \sum_{d_v=2}^{d_{v,max}} \lambda_{d_v} \times \widetilde{\Omega}_{d_v}^{(\ell+1)}(k), \quad 0.3cm \forall k \in \mathcal{A}_S \qquad (31)$$

For SP-NA-MS decoders, the DE update for VNU is implemented with (29), (30), and (31) where the effect of noise injection is added at VNUs. We can deduce that the DE update for VNU of SP-MS decoders setting $p_\Upsilon(i, k) = 1$ if $i = k$, otherwise $p_\gamma(i,k) = 0$, *i.e.* $\varphi = (0,0,0)$.

## Asymptotic Bit Error Probability

The asymptotic bit error probability can be deduced from the PMF of the APPs, which is obtained from the DE equations. Let $p_e^{(\ell)}$ denote the bit error probability at iteration $\ell$, which is computed from the PMF of all incoming messages to a VN in the $\ell^{th}$ iteration, and defined by

$$p_e^{(\ell)} = \frac{1}{2}\Gamma^{(\ell)}(0) + \sum_{i=-(N_q \times (d_{v,max}+1)+(d_{v,max}+\xi)/2)}^{-1} \Gamma^{(\ell)}(i), \qquad (32)$$

where $\Gamma^{(\ell)}(k)$,

$$k \in \mathcal{A}_{app},$$

denotes the PMF of the APP at the end of the $\ell^{th}$ iteration for Sign-Preserving decoders. We can compute $\Gamma^{(\ell)}(k)$ as follows

$$\Gamma^{(\ell)}(k) = \sum_{d_v=2}^{d_{v,max}} \lambda_{d_v} \times \Gamma_{d_v}^{(\ell)}(k), \quad 0.3cm \forall k \in \mathcal{A}_{app}$$

where $\Gamma_{d_v}^{(\ell)}(k)$ is computed as

$$\Gamma_{d_v}^{(\ell)}(k) = \sum_{(t,i_1,\ldots,i_{d_v}):\Psi_v(t,i_1,\ldots,i_{d_v})=k} \Omega^{(0)}(t)\Theta^{(\ell)}(i_1)\ldots\Theta^{(\ell)}(i_{d_v}), \forall k \in \mathcal{A}_{app}$$

The evolution of $p_e^{(\ell)}$ with the iterations characterizes whether the Sign Preserving decoder converges or diverges in the asymptotic limit of the codeword length. When the number of iterations $\ell$ goes to infinity, we obtain the asymptotic error probability $p_e^{(+\infty)}$. For SP-MS decoders which is a noiseless decoder, the decoder converges to zero error probability and successful decoding is declared, *i.e.* $p_e^{(+\infty)} = 0$ .

In the case of SP-NA-MS decoders, contrary to the noiseless case, $p_e^{(+\infty)}$ is not necessarily equal to zero when the noisy DE converges and corrects the channel noise. It depends mainly on the chosen error model and the computing units to which it is applied. For noisy decoders, the lower bound of the asymptotic bit error probability, denoted $p_e^{(lb)}$ , has a mathematical expression that we can compute, but for other noise models is very difficult to find it. Hence, the bit error probability is lower-bounded as

$$ p_e^{(\ell)} \geq p_e^{(lb)} > 0. $$

**Density Evolution threshold**

The DE threshold $\delta$ is expressed as a crossover probability ($\delta = \varepsilon^*$) for the BSC or as a standard deviation ($\delta = \sigma^*$) for the BI-AWGN channel, with the objective of separating two regions of channel noise parameters. The first region composed of values smaller than $\delta$ corresponds to the region where the DE converges to the zero error probability fixed point in less than $L_{max}$ iterations of the DE recursion. The second region composed of values greater than $\delta$ corresponds to when the DE does not converge. In this later case, the DE converges to a fixed point which does not represent the zero error probability. Then the DE threshold can be considered as a point of discontinuity between these two regions.
We compute the DE threshold performing a dichotomic search and stopping when the bisection search interval size is lower than some precision *prec.* The DE estimation procedure is performed choosing a target residual error probability $\eta > p_e^{(lb)}$ , and declaring convergence of the noisy DE recursion when $p_e^{(+\infty)}$ is less than or equal to $\eta$.
The noisy-DE threshold is a function of the code family, parametrized by its degree distribution ($\lambda(x),\rho(x)$), of the number of precision bits $q$, of the value of the channel gain factor $\alpha$, and of the values of the transition probabilities of the noise model ($\varphi_s,\varphi_a,\varphi_0$). The algorithm 1 describes the procedure to compute the noisy-DE threshold $\tilde{\delta}$ for the SP-NA-MS decoders for a fixed precision $q$, a fixed degree distribution ($\lambda(x),\rho(x)$), a fixed channel gain factor $\alpha$, and a fixed noise model parameters ($\varphi_s,\varphi_a,\varphi_0$).
For the BI-AWGN channel, $\delta$ is the maximum value of $\sigma$ or the minimum SNR at which the DE converges to a zero error probability can be expressed as $\delta_{db} = 10\log_{10}\left(\frac{1}{2\,R\,\sigma^{*2}}\right)$ where $\sigma^* = \delta$, and $R$ is the rate of the code.
In this paper, we use $\tilde{\delta}$ to jointly optimize the noise model parameters ($\varphi_s,\varphi_a,\varphi_0$) and the channel gain factor $\alpha$ for a fixed precision $q$ and a fixed degree distribution ($\lambda(x),\rho(x)$) as follows

$$ (\varphi_s^*,\varphi_a^*,\varphi_0^*,\alpha^*) = arg \max_{(\varphi_s,\varphi_a,\varphi_0,\alpha)} \{\tilde{\delta}(\lambda(x),\rho(x),q,\alpha,(\varphi_s,\varphi_a,\varphi_0))\}. \quad (33) $$

The optimization of the transition probabilities of the noise model Y, and the channel gain factor $\alpha$ is made using a *greedy* algorithm which computes a local maximum DE threshold. For noiseless decoders, the optimization (33) is reduced to the optimum channel gain factor $\alpha^*$ which is computed performing a grid-search.

**Asymptotic Analysis of Sign-Preserving Min-Sum Decoders**

Asymptotic Analysis of SP-MS Decoders for Regular LDPC codes

In this section, we consider the ensemble of ($d_v,d_c$)-regular LDPC codes with code rate $R \in \{1/2,3/4\}$ for $d_v \in \{3,4,5\}$, $R = 0.8413$ for the IEEE 802.3 ETHERNET code, and quantized decoders with $q \in \{3,4\}$.
The DE thresholds of the noiseless classical MS and OMS decoders are given in Table 2. It can be seen that the OMS is almost always superior to the MS for the considered cases, except for the regular $d_v = 3$ LDPC codes with low precision $q = 3$.

Table 2 - DE thresholds of classical MS and OMS decoders ($d_v$,$d_c$)-regular LDPC code, BI-AWGN channel

| | | ($d_v = 3, d_c = 6$) | | ($d_v = 4, d_c = 8$) | | ($d_v = 5, d_c = 10$) | | ($d_v = 6, d_c = 32$) | |
|---|---|---|---|---|---|---|---|---|---|
| q | $\lambda_v$ | $\alpha^*$ | $\delta_{db}$ | $\alpha^*$ | $\delta_{db}$ | $\alpha^*$ | $\delta_{db}$ | $\alpha^*$ | $\delta_{db}$ |
| 3 bits | 0 | 0.9375 | **1.7888** | 0.8125 | 2.7360 | 0.6300 | 3.4117 | 0.455 | 4.0812 |
| | 1 | 1.0625 | 2.2039 | 1.25 | **2.3219** | 1.1500 | **2.7079** | 0.84 | **3.5928** |
| 4 bits | 0 | 2.0 | 1.6437 | 1.625 | 2.5389 | 1.2500 | 3.1772 | 1.035 | 3.8154 |
| | 1 | 1.875 | **1.3481** | 1.75 | **1.7509** | 1.5900 | **2.2306** | 1.28 | **3.1685** |
| 5 bits | 0 | 4.0 | 1.6132 | 3.25 | 2.4948 | 2.3000 | 3.1126 | 1.985 | 3.7506 |
| | 1 | 2.625 | **1.2154** | 2.0 | **1.7061** | 1.6900 | **2.2089** | 1.45 | **3.1400** |
| | | | | | | | | | |
| | | ($d_v = 3, d_c = 12$) | | ($d_v = 4, d_c = 16$) | | ($d_v = 5, d_c = 20$) | | | |
| q | $\lambda_v$ | $\alpha^*$ | $\delta_{db}$ | $\alpha^*$ | $\delta_{db}$ | $\alpha^*$ | $\delta_{db}$ | | |
| 3 bits | 0 | 0.625 | **2.7316** | 0.6875 | 3.1550 | 0.5600 | 3.6449 | | |
| | 1 | 0.9375 | 3.1343 | 0.9375 | **3.0632** | 0.9200 | **3.2312** | | |
| 4 bits | 0 | 1.25 | 2.5646 | 1.375 | 2.9441 | 1.4000 | 3.3917 | | |
| | 1 | 1.5 | **2.4484** | 1.5 | **2.5292** | 1.3900 | **2.7620** | | |
| 5 bits | 0 | 2.5 | 2.5268 | 2.75 | 2.8991 | 2.4700 | 3.3373 | | |
| | 1 | 2.25 | **2.3040** | 1.875 | **2.4606** | 1.6100 | **2.7238** | | |

In Table 3, we indicate the noisy and noiseless DE thresholds obtained with (33), we also show the DE gains obtained comparing the best thresholds indicated in bold in Table 2 and the noisy (resp. noiseless) thresholds of SP-NA-MS decoders (resp. SP-MS decoders). Moreover, we list the best noisy DE thresholds of NAN-MS decoders.

Table 3 - Noisy DE thresholds of SP-NA-MS decoders and DE thresholds of SP-MS decoders

| | | SP-NA-MS decoders | | | | | | NAN-MS | SP-MS decoders | | | |
|---|---|---|---|---|---|---|---|---|---|---|---|---|
| ($d_v,d_c$) | a | $\alpha^*$ | $\varphi_s^*$ | $\varphi_a^*$ | $\varphi_0^*$ | $\tilde{\delta}_{db}$ | DE gain | $\tilde{\delta}_{db}$ - NIV | $\alpha^*$ | ( $\varphi_s^*, \varphi_a^*, \varphi_0^*$ ) | $\tilde{\delta}_{db}$ | DE gain |
| (3,6) | 3 bits | 0.96 | 0.987 | 0.712 | 0.000 | **1.4994** | **0.2894** | 1.5711 | 0.95 | (1, 1, 0) | **1.5096** | **0.2792** |
| | 4 bits | 1.79 | 1.000 | 1000 | 0.000 | **1.2688** | **0.0793** | 1.2877 | 1.79 | (1, 1, 0) | **1.2688** | **0.0793** |
| (3,12) | 3 bits | 0.72 | 1000 | 0.725 | 0.000 | **2.5421** | **0.1895** | 2.5989 | 0.71 | (1, 1, 0) | **2.5468** | **0.1848** |
| | 4 bits | 1.34 | 1000 | 0.938 | 0.000 | **2.3596** | **0.0888** | 2.3777 | 1.36 | (1, 1, 0) | **2.3600** | **0.0884** |
| (4,8) | 3 bits | 101 | 0.900 | 1000 | 1.000 | **1.9820** | **0.3399** | 2.1056 | 1.01 | (1, 1, 1) | **1.9824** | **0.3395** |
| | 4 bits | 1.54 | 1000 | 1000 | 1000 | **1.7306** | **0.0203** | 1.7411 | 1.54 | (1, 1, 1) | **1.7306** | **0.0203** |
| (4,16) | 3 bits | 0.75 | 1000 | 0.962 | 0.712 | **2.7448** | **0.3184** | 2.8121 | 0.78 | (1, 1, 1) | **2.7459** | **0.3173** |
| | 4 bits | 1.30 | 1.000 | 1000 | 1000 | **2.4941** | **0.0351** | 2.5077 | 1.30 | (1, 1, 1) | **2.4941** | **0.0351** |
| (5,10) | 3 bits | 1.12 | 1000 | 1000 | 0.987 | **2.4908** | **0.2171** | 2.6417 | 1.12 | (1, 1, 1) | **2.4908** | **0.2171** |
| | 4 bits | 1.57 | 1000 | 1000 | 1000 | **2.2196** | **0.0110** | 2.2306 | 1.57 | (1, 1, 1) | **2.2196** | **0.0110** |
| (5,20) | 3 bits | 0.87 | 1000 | 1000 | 0.838 | **3.0106** | **0.2206** | 3.1400 | 0.89 | (1, 1, 1) | **3.0137** | **0.2175** |
| | 4 bits | 1.39 | 1000 | 1000 | 1000 | **2.7412** | **0.0208** | 2.7596 | 1.39 | (1, 1, 1) | **2.7412** | **0.0208** |
| (6,32) | 3 bits | 0.74 | 1000 | 1000 | 1000 | **3.3963** | **0.1965** | 3.5766 | 0.74 | (1, 1, 1) | **3.3963** | **0.1965** |
| | 4 bits | 1.18 | 1000 | 1000 | 1000 | **3.1787** | **-0.0102** | 3.1685 | 1.18 | (1, 1, 1) | **3.1787** | **-0.0102** |

Several conclusions can be derived from this analysis. First, the DE thresholds of the SP-NA-MS decoders are almost always better than the DE thresholds of the noiseless classical decoders. The DE gains for the SP-NA-MS decoders are quite important for $q = 3$, the largest gain obtained is around 0.3399 dB for ($d_v = 4$, $d_c = 8$). While the DE gains are smaller for the largest precision $q = 4$. We can observe a loss of around 0.0102 dB for ($d_v = 6$, $d_c = 32$) and $q$

= 4. From this analysis, we can conclude that the preservation of the sign of messages and the noise injection are more and more beneficial as the decoders are implemented in low precision. Second, when comparing the noisy thresholds of SP-NA-MS and NAN-MS decoders, one can observe that the SP-NA-MS decoders achieve better DE thresholds for almost all $(d_v, d_c)$-regular LDPC codes tested, the only exception appears for the regular $(d_v = 6, d_c = 32)$ LDPC code and $q = 4$. The largest gain obtained, when comparing the SP-NA-MS thresholds and NAN-MS thresholds, is around 0.1803 dB for the regular $(d_v = 6, d_c = 32)$ LDPC code and $q = 3$. A third remark comes from the interpretation of the optimum $\varphi^*$ obtained through the DE analysis. We have $\varphi_0^* = 0$ for regular $d_v = 3$ LDPC codes, this makes sense because $d_v = 3$ is small enough to transform $\hat{m} = \pm 1$ into $\tilde{m} = \pm 0$, which gives to $\tilde{m}_{v_n \to c_m}^{(\ell)}$ a reliability of zero and which could not help to *extrinsic* messages become more and more reliable at each new decoding iteration. For regular $d_v > 3$ LDPC codes, we have almost always $\varphi_0^* = 1$, hence, one can conclude that for regular $d_v > 3$ LDPC codes, the transformation from $\hat{m} = \pm 1$ to $\tilde{m} = \pm 0$, does not affect the decoding process. Note that in [?], the transformation from $\hat{m} = \pm 1$ to $\tilde{m} = 0$ should not be allowed since $\tilde{m} = 0 \in A_c$ erase the bit value. Finally, all SP-NA-MS decoders can be implemented as deterministic decoders since the values of the transition probabilities are close or equal to 0 or 1. The optimum noise parameters $\varphi^*$ are close to $(\varphi_s^*, \varphi_a^*, \varphi_0^*) = (1,1,0)$ for the regular $d_v = 3$ LDPC codes. While in the case of the regular $d_v > 3$ LDPC codes, $\varphi^*$ are close to $(\varphi_s^*, \varphi_a^*, \varphi_0^*) = (1,1,1)$ which correspond to a deterministic SP-OMS decoder.

**Asymptotic Analysis of SP-MS Decoders for Irregular LDPC codes**

In the previous section we have seen that the optimum noise parameters ( $\varphi_s^*, \varphi_a^*, \varphi_0^*$ ) and the respective gains of SP-NA-MS decoders depend on the VN degree. For LDPC codes with irregular VN distribution, we propose therefore to extend our approach by considering a noise injection model Y with different values of the transition probabilities for the different connection degrees.

We denote by $\Upsilon^{(2)} : \boldsymbol{\varphi}^{(2)} = \left( \varphi_s^{(2)}, \varphi_a^{(2)}, \varphi_0^{(2)} \right)$ the model which injects noise at VNs of degree $d_v = 2$. Similarly, let $\Upsilon^{(3)} : \boldsymbol{\varphi}^{(3)} = \left( \varphi_s^{(3)}, \varphi_a^{(3)}, \varphi_0^{(3)} \right)$ denote the noise model for the VNs of degree $d_v = 3$. Finally, we decide to use the same model for all other VNs with degrees $d_v \geq 4$, denoted $\Upsilon^{(\geq 4)} : \boldsymbol{\varphi}^{(\geq 4)} = \left( \varphi_s^{(\geq 4)}, \varphi_a^{(\geq 4)}, \varphi_0^{(\geq 4)} \right)$.

The optimization of the transition probabilities for an irregular LDPC code with distribution $(\lambda(x), \rho(x))$ is still performed by the maximization of the noisy DE thresholds:

$$\left( \boldsymbol{\varphi}^{(2)*}, \boldsymbol{\varphi}^{(3)*}, \boldsymbol{\varphi}^{(\geq 4)*}, \alpha^* \right) =$$
$$arg \max_{(\boldsymbol{\varphi}^{(2)}, \boldsymbol{\varphi}^{(3)}, \boldsymbol{\varphi}^{(\geq 4)}, \alpha)} \left\{ \tilde{\delta} \left( \lambda(x), \rho(x), q, \alpha, \boldsymbol{\varphi}^{(2)}, \boldsymbol{\varphi}^{(3)}, \boldsymbol{\varphi}^{(\geq 4)} \right) \right\}. \qquad (34)$$

For our analysis, we consider the ensemble of irregular LDPC codes which follow the distribution of the rate $R \in \{1/2, 3/4\}$, length $N = 2304$ code described in the WIMAX standard. The degree distribution for the rate 1/2 code is $\lambda(x) = \frac{22}{76} x + \frac{24}{76} x^2 + \frac{30}{76} x^5$ and $\rho(x) = \frac{48}{76} x^5 + \frac{28}{76} x^6$ , while for the rate 3/4 B code is $\lambda(x) = \frac{10}{88} x + \frac{36}{88} x^2 + \frac{42}{88} x^5$ and $\rho(x) = \frac{28}{88} x^{13} + \frac{60}{88} x^{14}$ . For these distributions, we indicate in Table 4 the DE thresholds of the noiseless MS decoder and the noiseless OMS decoder.

Table 4: DE thresholds of noiseless MS decoders and noiseless OMS decoders with offset value $\lambda_v$ = 1 for the WIMAX degree distribution

| Irreg ular LDPC code, BI-AWGN channel | | | | | |
|---|---|---|---|---|---|
| | | $R = 1/2$ | | $R = 3/4$ | |
| $q$ | AV | $\alpha^*$ | $\delta_{db}$ | $\alpha^*$ | $\delta_{db}$ 1* |
| 3 bits | 0 | 0.44 | **1.8310** | 0.66 | **2.8236** |
| | 1 | 0.40 | 5.2283 | 0.50 | 3.4406 |
| 4 bits | 0 | 1.07 | **1.3941** | 1.29 | 2.6150 |
| | 1 | 0.80 | 2.8140 | 1.42 | **2.2416** |
| 5 bits | 0 | 2.30 | 1.3013 | 2.50 | 2.5654 |
| | 1 | 1.55 | **1.1828** | 1.97 | **2.1637** |

Noisy DE thresholds are summarized in Table 5, where we indicate the optimum values of $\alpha$ and of the noise parameters for the different degrees. Those results confirm the conclusions of the regular LDPC codes analysis: *(i)* the DE thresholds of SP-NA-MS decoders are better than the DE thresholds of NAN-MS decoders, *(ii)* the optimum value for $\varphi_0^*$ is 0 or it is close to 0 for $d_v$ = 3 VNs and for $q$ = 3, and *(iii)* some of the optimized models are not probabilistic since the optimized values of the transition probabilities are very close to 0 or 1.

Table 5: DE thresholds of SP-NA-MS and SP-MS decoders for the WIMAX degree distribution

| $R$ | a | $\alpha^*$ | $d_v$ | $\varphi_s^*$ | $\varphi_a^*$ | $\varphi_0^*$ | $\delta_{db}$ | DE gain | $\delta_{db}$ - NIV | $\alpha^*$ | ( $\varphi_s^*, \varphi_a^*, \varphi_0^*$ ) | $\delta_{db}$ | DE gain |
|---|---|---|---|---|---|---|---|---|---|---|---|---|---|
| | | | | | SP-NA-MS decoders | | | | NAN-MS | | SP-MS decoders | | |
| 1/2 | 3 bits | 0.65 | 2 3 >_ 4 | 0.000 0.000 1000 | 0.000 0.162 1000 | 0.000 0.000 1000 | **1.3997** | **0.4313** | 1.6236 | 0.65 | (0,0,0) (0,0,0) (1,1,1) | **1.4003** | **0.4307** |
| | 4 bits | 1.24 | 2 3 >_ 4 | 0.000 0.250 1.000 | 0.000 1000 1000 | 0.000 0.375 1000 | **0.9547** | **0.4394** | 0.9995 | 1.24 | (0,0,0) (0,1,0) (1,1,1) | **0.9582** | **0.4359** |
| 3/4 | 3 bits | 0.81 | 2 3 >_ 4 | 0.000 1000 1000 | 0.000 0.687 1000 | 0.000 0.000 1000 | **2.4433** | **0.3803** | 2.5323 | 0.81 | (0,0,0) (1,1,0) (1,1,1) | **2.4451** | **0.3785** |
| | 4 bits | 1.48 | 2 3 >_ 4 | 1000 1000 1.000 | 0.788 1000 1000 | 0.000 1.000 1000 | **2.2110** | **0.0306** | 2.2138 | 1.49 | (1,1,0) (1,1,1) (1,1,1) | **2.2111** | **0.0305** |

Another conclusion can be driven from these tables. From the DE analysis we can conclude that the noise should not be injected on degree $d_v$ = 2 VNs for the case of low precision $q$ = 3, since we obtain always

$$(\varphi_s^{(2)}, \varphi_a^{(2)}, \varphi_0^{(2)}) \simeq (0,0,0)$$

. While for the largest precision $q$ = 4, the noise should be injected on degree $d_v$ = 2 VNs for some cases. These observations, combined with the fact that the optimum values for $\varphi^{(\geq 4)*}$ are always 1, lead to the conclusion that injecting noise in SP-NA-MS decoders for irregular LDPC codes is especially important for the degree $d_v$ = 3 VNs (inject the noise on degree $d_v$ = 2 VNs will be depend on the degree distribution and the precision used)

Finally, the gains for SP-NA-MS decoder for irregular codes are larger than for the regular codes. The gain of the rate 1/2 code is 0.4313 dB for the lower precision $q$ = 3, and 0.4394 dB for the largest precision $q$ = 4. In the case of the rate 3/4 B code, the gains for the two considered precision $q$ = 3 and $q$ = 4 are smaller than the rate 1/2 code, a gain of 0.3803 dB for $q$ = 3, and a gain of 0.0306 dB for $q$ = 4.

**Finite Length Performance**

In this section we present the frame error rate (FER) performance for noiseless classical MS, noiseless classical OMS, and SP-MS decoders. We analyze the quantized decoder performance over the BI-AWGN channel.

The considered decoders are the ones with the best DE thresholds, indicated in bold in Table 2 and Table 3. The noiseless classical OMS decoder performance for quantization $q$ = 5 are also show as benchmark.

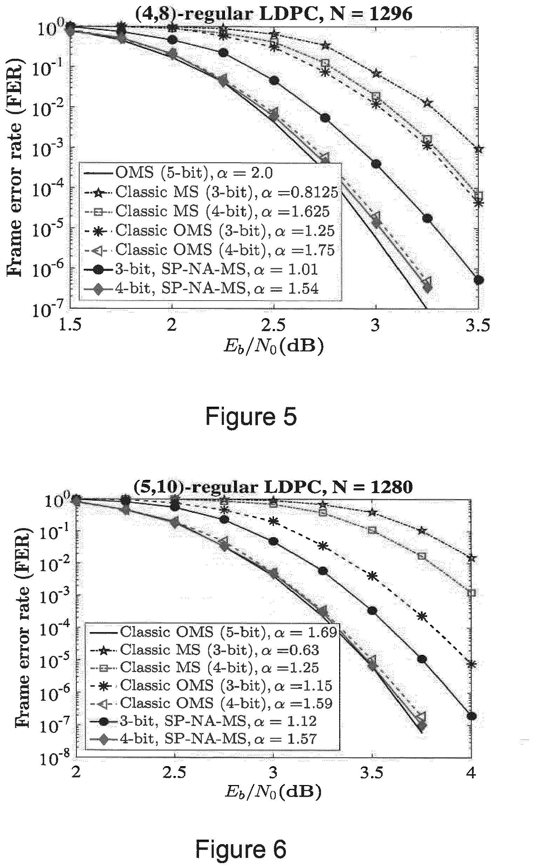

A maximum of 100 iterations has been set for $d_v$ = 3, $d_v$ = 4, and $d_v$ = 5 LDPC decoders. Figure 4 shows the FER performance comparisons between the classical MS, classical OMS, and SP-MS decoders, for the two considered precisions $q$ = 3 and $q$ = 4, and for the regular ($d_v$ = 3, $d_c$ = 6) QC-LDPC code. Figure 5 and Figure 6 draw the same curves for the regular ($d_v$ = 4, $d_c$ = 8) QC-LDPC code and the regular ($d_v$ = 5, $d_c$ = 10) QC-LDPC code, respectively.

A first conclusion is that the finite length FER performance are in accordance with the gains predicted by the DE analysis. We observe in the waterfall ( *i.e.* at FER = $10^{-2}$) an SNR gain for the SP-MS decoders which corresponds to the threshold differences (Table 3 and Table 5): around 0.27 dB ($q$ = 3,$d_v$ = 3,$R$ = 1/2), 0.06 dB for ($q$ = 4,$d_v$ = 3,$R$ = 1/2), 0.32 dB for ($q$ = 3,$d_v$ = 4,$R$ = 1/2), the same performance for ($q$ = 4,$d_v$ = 4,$R$ = 1/2), 0.20 dB for ($q$ = 3,$d_v$ = 5,$R$ = 1/2), the same performance for ($q$ = 4,$d_v$ = 5,$R$ = 1/2). We have made the same analysis for LDPC codes with rate $R$ = 3/4, *i.e.* ($d_v$ = 3, $d_c$ = 12), ($d_v$ = 4, $d_c$ = 16), and ($d_v$ = 5, $d_c$ = 20), and obtained the same conclusions.

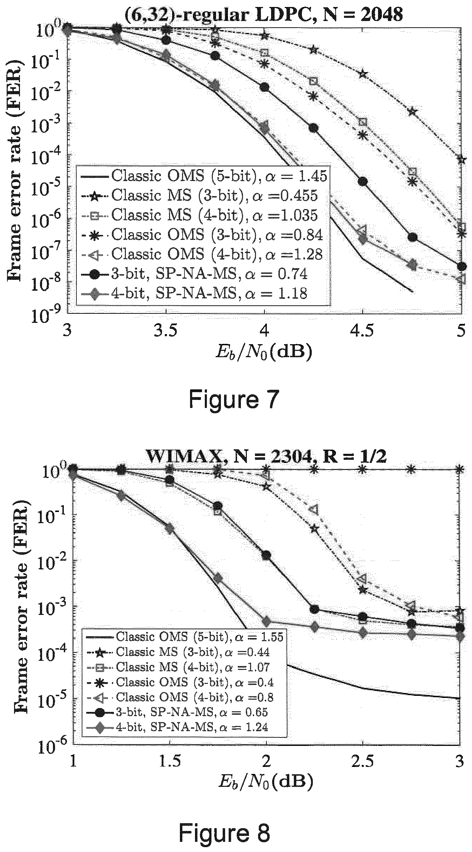

Simulation results for the IEEE 802.3 ETHERNET code are provided on Figure 7 with a maximum of 30 iterations. Again, the SNR gains in the waterfall correspond to what was predicted with the DE analysis, with a 0.19 dB gain for $q$ = 3 and the same performance for $q$ = 4.

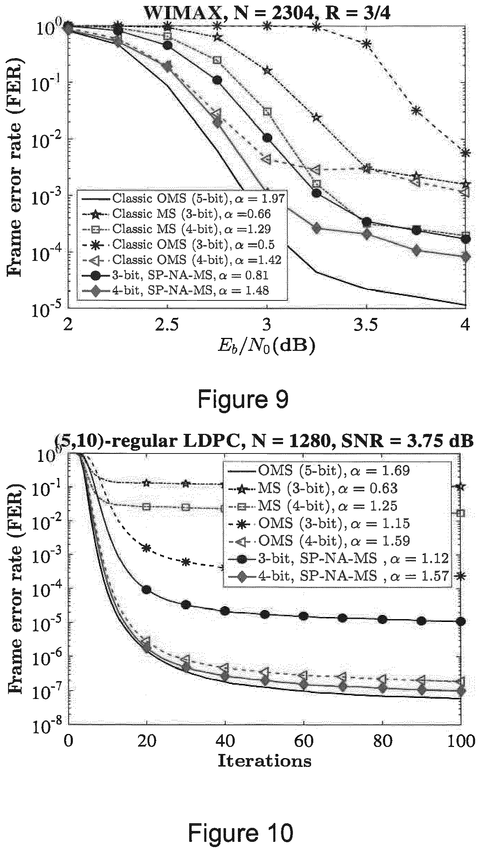

Similarly, Figure 8 and Figure 9 present simulation results for the WIMAX rate 1/2 LDPC code and the WIMAX rate 3/4 B LDPC code, respectively, for a maximum of 100 iterations. We observe again that the SNR gains in the waterfall region are in agreement with the gains predicted by the DE analysis, with a 0.40 dB gain for ($q$ = 3, $R$ = 1/2), a 0.40 dB gain for ($q$ = 4, $R$ = 1/2), a 0.37 dB gain for ($q$ = 3, $R$ = 3/4), and a 0.03 dB gain for ($q$ = 3, $R$ = 3/4).

Additionally, for the WIMAX rate 1/2 LDPC code, the 3-bit SP-MS decoder has the same FER performance as the 4-bit MS decoder. In the waterfall region, the 4-bit SP-MS decoder has the same FER performance as the 5-bit OMS decoder, while in the error floor region, the 5-bit OMS decoder has better FER performance than the 4-bit SP-MS decoder. In the case of the WIMAX rate 3/4 B LDPC code, The SP-MS decoders have better FER performance than the MS and the OMS decoders in the error floor region.

As a remark, we can also see that the preservation of the sign of messages does not seem to have an influence in the error floor of the decoders, since all the curves have similar slopes in the low FER region. This means that the preservation of the sign of messages does not correct the dominant error events due to trapping sets.

The study presented in details here above is a particular case where

$$q_{ch} = q \quad A_L = A_S = A_C.$$

Another particular case of study occurs when $q_{ch}$ = $q$ + 1, and $A_L \neq A_S = A_C$. For these conditions some results obtained in the study of the IEEE 802.3 ETHERNET code are presented.

In the initialization stage of the SP-MS decoder, i.e. first iteration, the variable-to-check messages are computed as $m_{v_n \to c_m}^{(1)} = \min(\max(I_n, - N_q), +N_q)$ where $c_m \in V_{(vn)}$.

First, we present the DE thresholds $\delta$ obtained for different precision $q_{ch}$ and $q$. The following table shows the DE thresholds for optimized SP-MS decoders.

| $(d_v, d_c)$ | $(q_{ch}, q)$ | $\alpha$ | $\delta$ |
|---|---|---|---|
| (6,32) | (3,2) | 0.74 | 3.3979 |
| | (3,3) | 0.74 | 3.3963 |
| | (4,3) | 1.22 | 3.1740 |
| | (4,4) | 1.18 | 3.1787 |

From the table we can conclude that the SP-MS decoder implemented with precision $q_{ch}$ = 3 and $q$ = 2 (resp. $q_{ch}$ = 4 and $q$ = 3) has the same performance as the SP-MS decoder implemented with precision $q_{ch}$ = $q$ = 3 (resp. $q_{ch}$ = $q$ = 4 ). In the implementation part this has a great impact, since it goes from the precision $q$ = $q_{ch}$ of the messages to the precision $q$ = $q_{ch}$ - 1, this reduces the number of wires between VNs and CNs in an ASIC implementation.

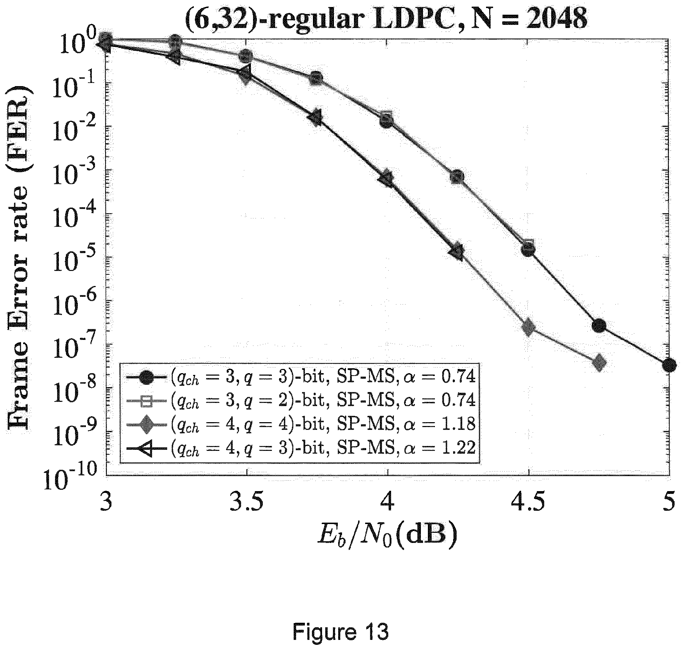

Simulation results for the IEEE 802.3 ETHERNET code are provided on Fig. 13 with a maximum of 30 iterations. From the finite length FER performance, we can conclude that the performances of the SP-MS are in accordance with the performances predicted by the DE analysis.

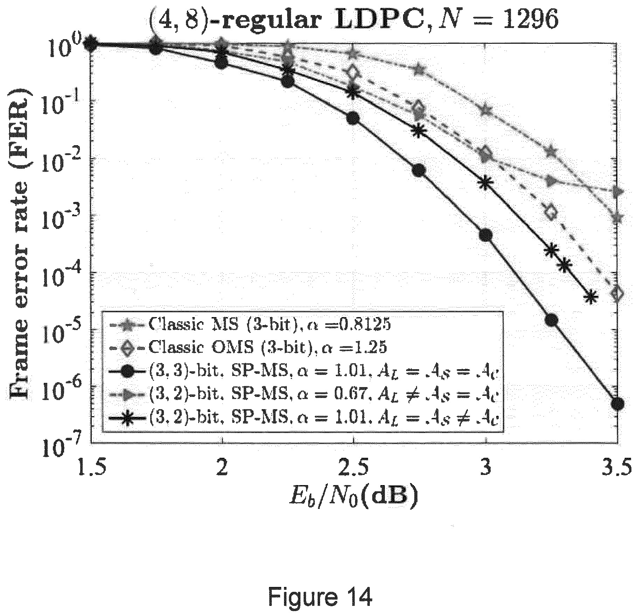

In general, the choice of the alphabets $A_L$, $A_S$, and $A_C$ (i.e. the precision of LLRs, v-to-c messages, and c-to-v messages) will depend on the code with which the SP-MS decoder works. Fig. 14 illustrates the performances of the SP-MS decoder in comparison with other decoders. Considering the case of $q_{ch}$=$q$+1 and $A_L{\neq}A_S$=$A_C$ for the regular ($d_v$=4,$d_c$=8) QC-LDPC code, we can note in the Fig. 14 that the SP-MS decoder exhibits poor performance having an early error floor. Note that for q=2, we have As=Ac={-1,-0,+0,+1} and $A_L$={-3,-2,-1,-0,+0,+1,+2,+3}.

In Fig. 14 one can also see that the SP-MS decoder considering $q_{ch}$=$q$ and $A_L$=$A_S$=$A_C$ has the best performance. We have $A_L$=$A_S$=$A_C$ ={-3,-2,-1,-0,+0,+1,+2,+3} for q=3.

Another particular case of study occurs when considering $A_L$=$A_S{\neq}A_C$, this means that the precision of the v-to-c messages $m_{vn{\rightarrow}cm}{}^{(l)}$ and the c-to-v $m(c_m{\rightarrow}v_n)^{(l)}$ messages are different. Let us consider the case of $q_{ch}$=3 bits of precision for the LLR and the v-to-c messages, hence $A_L$=$A_S$={-3,-2,-1,-0,+0,+1,+2,+3}. Let us also consider the case of q=2 bits of precision for the c-to-v messages, hence $A_C$={-1,-0,+0,+1}.

The CNs have 3-bit inputs and must generate 2-bit outputs. Using the update rule at CN, see equation (14), the c-to-v $m_{cm{\rightarrow}vn}{}^{(l)}$ messages belongs to the alphabet As, i.e. $q_{ch}$=3 bits of precision. In order to use q=2 bits of precision for the c-to-v messages we consider the following mapping.

$$m_{c_m \to v_n}^{(\ell)} = \begin{cases} \left(\text{sign}\left(m_{c_m \to v_n}^{(\ell)}\right), 0\right) & \text{, if abs}\left(m_{c_m \to v_n}^{(\ell)}\right) \in \{0,1\} \text{ and if } \ell < 11 \\ \left(\text{sign}\left(m_{c_m \to v_n}^{(\ell)}\right), 1\right) & \text{, if abs}\left(m_{c_m \to v_n}^{(\ell)}\right) \in \{2,3\} \text{ and if } \ell < 11 \\ \left(\text{sign}\left(m_{c_m \to v_n}^{(\ell)}\right), 0\right) & \text{, if abs}\left(m_{c_m \to v_n}^{(\ell)}\right) \in \{0\} \text{ and if } \ell \geq 11 \\ \left(\text{sign}\left(m_{c_m \to v_n}^{(\ell)}\right), 1\right) & \text{, if abs}\left(m_{c_m \to v_n}^{(\ell)}\right) \in \{1,2,3\} \text{ and if } \ell \geq 11 \end{cases}$$

Then the c-to-v messages belong to the alphabet $A_C$.

In the VNs, the c-to-v messages with amplitude abs($m_{cm{\rightarrow}vn}{}^{(l)}$)=1 are interpreted as messages of amplitude 2. With this interpretation the VNs perform the update rules.

Simulations results using a maximum of 100 iterations are provided on Fig 14. From the results we can see that the SP-MS decoder with $A_L$=$A_S{\neq}A_C$ has better performance than the MS and the OMS decoders. Comparing the SP-MS decoders, we clearly observe that the best SP-MS decoder is obtained using the same precision for messages and LLRs. We can also see that the early appearance of the error floor is eliminated by using 3 bits for the v-to-c messages and 2 bits for the c-to-v messages. In the implementation part this has a great impact because the number of wires in an ASIC implementation is reduced.

It can be observed that for example $A_L{\neq}A_S{\neq}A_C$ can be a good choice for the IEEE 802.3 ETHERNET code, $A_L$=$A_S$=$A_C$ can be a good choice for the WIMAX rate ½ LDPC code, and $A_L$=$A_S{\neq}A_C$ can be a good choice for the regular ($d_v$=4,$d_c$=8) QC-LDPC code.

A person of skill in the art would readily recognize that steps of various above-described methods can be performed by programmed computers. Herein, some embodiments are also intended to cover program storage devices, e.g., digital data storage media, which are machine or computer readable and encode machine- executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the figures., including any functional blocks labeled as "processors", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any routers shown in the figures are conceptual only. Their function may be carried out through the operation of program logic, through dedicated logic, through the interaction of program control and dedicated logic, or even manually, the particular technique being selectable by the implementer as more specifically understood from the context.

As used in this application, the term "circuitry" may refer to one or more or all of the following:

- hardware-only circuit implementations (such as implementations in only analog and/or digital circuitry) and
- combinations of hardware circuits and software, such as (as applicable):

  - a combination of analog and/or digital hardware circuit(s) with software/firmware and

  - any portions of hardware processor(s) with software (including digital signal processor(s)), software, and memory(ies) that work together to cause an apparatus, such as a mobile phone or server, to perform various functions) and

  - hardware circuit(s) and or processor(s), such as a microprocessor(s) or a portion of a microprocessor(s), that requires software (e.g., firmware) for operation, but the software may not be present when it is not needed for operation.

This definition of circuitry applies to all uses of this term in this application, including in any claims. As a further example, as used in this application, the term circuitry also covers an implementation of merely a hardware circuit or processor (or multiple processors) or portion of a hardware circuit or processor and its (or their) accompanying software and/or firmware. The term circuitry also covers, for example and if applicable to the particular claim element, a baseband integrated circuit or processor integrated circuit for a mobile device or a similar integrated circuit in server, a cellular network device, or other computing or network device.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention as defined by the claims. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions.

Algorithm 1 - Computation of the noisy DE threshold

    1) **[initialization]**
    Initialize interval limits $[\tilde{\delta}_1, \tilde{\delta}_2]$ with $\tilde{\delta}_1 < \tilde{\delta}_2$, such that DE succeeds for $\tilde{\delta} = \tilde{\delta}_1$ and fails for $\tilde{\delta} = \tilde{\delta}_2$. Further define $\tilde{\delta}_m = (\tilde{\delta}_1 + \tilde{\delta}_2)/2$.
    2) **[While** $|\hat{\delta}_2 - \hat{\delta}_1| > prec$**]**

        a) **[Perform noisy DE]**

            i) **[Initialize noisy DE]** Noisy DE is initialized with the equation (15) and $\sigma = \tilde{\delta}_m$
            ii) **[Iteration Loop]**

A) **[Compute PMF]** Apply recursively the sequence of five equations (27), (28), (29), (30), and (31) for $L_{max}$ iterations.

B) **[Break Iteration]** The iteration loop breaks when either the $p_e^{(\ell)} \leq \eta$ or $L_{max}$ is reached.

b) **[Noisy DE succeeds]**

If $p_e^{(\ell)} \leq \eta$ , the noisy DE has converged and we update $\hat{\delta}_1 = \hat{\delta}_m$, $\tilde{\delta}_2 = \tilde{\delta}_2$ and $\tilde{\delta}_m = (\tilde{\delta}_1 + \tilde{\delta}_2)/2$.

c) **[Noisy DE fails]**

If $p_e^{(L_{max})} > \eta$ , the noisy DE has not converged and we update $\tilde{\delta}_1 = \tilde{\delta}_1$, $\tilde{\delta}_2 = \tilde{\delta}_m$ and $\tilde{\delta}_m = (\tilde{\delta}_1 + \tilde{\delta}_2)/2$.

d) **[Tolerance]**

Compute the size of the interval $|\tilde{\delta}_2 - \tilde{\delta}_1|$ and stops the procedure if it is smaller than the threshold tolerance ( *e.g.* $10^{-10}$).

3) **[Threshold]**

$\tilde{\delta} = \tilde{\delta}_m$ is the noisy-DE threshold.

## Claims

1. Iterative decoder configured for decoding a codeword of a code represented by a Tanner graph and having a codeword length N, said iterative decoder comprising:

   • N variable nodes (VNs) $v_n$, n = 1 ... N, each variable node $v_n$ being configured to receive a log-likelihood ratio LLR $I_n$ of a channel decoded bit n of the codeword to be decoded, said LLR $I_n$ being defined on an alphabet $A_L$ of $q_{ch}$ quantization bits, $q_{ch}$ being an integer equal or greater than 2;
   • M constraint nodes (CNs) $c_m$, m = 1... M, $2 \leq M < N$ ;
   • the variable nodes and the constraint nodes representing nodes of the Tanner graph where the variable nodes and the constraint nodes are configured to exchange messages along edges of the Tanner graph;
   • each variable node $v_n$ being configured for estimating an a posteriori probability, APP, value of the $n^{th}$ bit of the codeword to be decoded and for sending messages $m_{v_n \to c_m}$ belonging to an alphabet $A_s$ of q quantization bits, $q \leq q_{ch}$, to the connected constraint nodes $c_m$ , where a set of connected constraint nodes is denoted $V_{(vn)}$, a degree $d_v$ of the variable node $v_n$ is defined as the size of the set $V_{(vn)}$, and the set $V_{(vn)}$ except the constraint node $c_m$ is denoted $V_{(vn)\backslash\{cm\}}$ ,
   • each constraint nodes $c_m$ being configured for testing the received message with predetermined constraints and sending messages $m_{c_m \to v_n}$, messages belonging to an alphabet $A_c$ of q' quantization bits, having a different or similar set of value than $A_s$, to the connected variable nodes $v_n$;
   • the message emissions being repeated until the decoding of the codeword is achieved successfully or a predetermined number of iterations is reached; **characterized in that**
   • the LLR $I_n$ and the messages $m_{v_n \to c_m}$ and $m_{c_m \to v_n}$ are coded according to a sign-and-magnitude code in the alphabets $A_L$, $A_s$ and $A_c$ symmetric around zero, $A_L$ = {-N$_{qch}$,..., -1, -0, +0, +1, ...,+N$_{qch}$}, $A_s$ = {-N$_q$, ... , -1, -0, +0, +1, ...,+N$_q$}, $A_c$ = {-N$_{q'}$,..., -1, -0, +0, +1, ...,+N$_{q'}$} in which the sign indicates the estimated bit value and the magnitude represents its reliability; and
   • each variable node $v_n$, for each iteration *l*, is configured to compute:
   • sign-preserving factors, for each connected constraint node $c_m$ as a sum of a ponderated sign of the LLR $I_n$ and a sum of the signs of all messages, except for the message coming from $c_m$, received from the connected constraint nodes at iteration *l*:

   $$\mu_{v_n \to c_m}^{(\ell)} = \xi \times sign\,(I_n) + \sum_{c \in V(v_n)\backslash\{c_m\}} sign\left(m_{c \to v_n}^{(\ell)}\right)$$ where $\xi$ is a positive or a null integer, and
   • messages to connected constraint nodes $c_m$ for iteration *l* +1 in two steps:

   $$m_{v_n \to c_m}^{(\ell+1),U} = I_n + \frac{1}{2} \times \mu_{v_n \to c_m}^{(\ell)} + \sum_{c \in V(v_n)\backslash\{c_m\}} \left(m_{c \to v_n}^{(\ell)}\right)$$ and

$$m_{v_n \to c_m}^{(\ell+1)} = \left( \text{sign}\left(m_{v_n \to c_m}^{(\ell+1),U}\right), \mathcal{S}\left(\text{floor}\left(\text{abs}\left(m_{v_n \to c_m}^{(\ell+1),U}\right)\right)\right)\right),$$

where S is a function from the set of values that can take $\text{floor}\left(\text{abs}\left(m_{v_n \to c_m}^{(\ell+1),U}\right)\right)$ to the alphabet $A_s$.

2. The iterative decoder of claim 1 wherein $\xi$ equal to 0 if $d_v = 2$, equal to 1 if $d_v > 2$ and $d_v$ is odd, and equal to 2 if $d_v > 2$ and $d_v$ is even.

3. The iterative decoder of claim 1 or 2, wherein the constraint nodes use parity check, a convolution code or any block code as constraints.

4. The iterative decoder of claim 3, wherein the codeword is coded by LDPC and the constraint nodes are check nodes.

5. The iterative decoder of any preceding claim, wherein the function S is defined as S(x) = min(max( x - $\lambda$(x), 0),+Nq), where $\lambda$(x) is an integer offset value depending on the value of x.

6. The iterative decoder of claim 5, wherein $\lambda$(x) is a random variable that can take its value in a predefined set of values according to a predefined law.

7. The iterative decoder of any preceding claim, wherein the alphabets $A_s$ and $A_c$ are identical.

8. The iterative decoder of any preceding claim wherein the means comprises

   • at least one processor; and
   • at least one memory including computer program code, the at least one memory and computer program code configured to, with the at least one processor, cause the performance of the decoder.

9. An iterative decoding method for decoding a codeword of a code represented by a Tanner graph and having a codeword length N, by an iterative decoder according to any one of claims 1 to 8, the iterative decoder comprising N variable nodes (VNs) $v_n$, n = 1... N, and M constraint nodes (CNs) $c_m$, m = 1...M, $2 \leq M < N$, said variable and constraint nodes representing nodes of the Tanner graph, said method comprising the following steps of :

   • reception and storage (21) of a log-likelihood ratio LLR $l_n$ of a channel decoded bit n of the codeword to be decoded by the variable node vn, n = 1... N, said LLR $l_n$ being defined on an alphabet $A_L$ of $q_{ch}$ quantization bits, $q_{ch}$ being an integer equal or greater than 2;
   • estimation by each variable node $v_n$ of an a posteriori probability, APP, value of the $n^{th}$ bit of the codeword to be decoded,
   • emission (23) of messages $m_{v_n \to c_m}$ from each variable node $v_n$ to the connected constraint nodes $c_m$ , said messages belonging to an alphabet $A_s$ of q quantization bits, $q \leq q_{ch}$, where a set of connected constraint nodes is denoted $V_{(vn)}$, a degree $d_v$ of the variable node $v_n$ is defined as the size of the set $V_{(vn)}$, and the set $V_{(vn)}$ except the constraint node $c_m$ is denoted l' $V_{(vn)\backslash\{cm\}}$,
   • reception of the messages and verification (25) of the received messages with predetermined constraints by the constraint nodes $c_m$;
   • emission (27) of messages $m_{c_m \to v_n}$ containing a possible candidate value for a variable n solving the constraints to the connected variable nodes $v_n$, said messages belonging to an alphabet $A_c$ of q' quantization bits;

     ◦ repetition of the message emissions until the decoding of the codeword is achieved successfully or a predetermined number of iterations is achieved;

   **characterized in that**

     ◦ the LLR $l_n$ and the messages $m_{v_n \to c_m}$ and $m_{c_m \to v_n}$ are coded according to a sign-and-magnitude code in the alphabets $A_L$, $A_s$ and $A_c$ symmetric around zero, $A_L$={-$N_{qch}$ ,...., -1, -0, +0, +1, ..., +$N_{qch}$}, $A_s$={-$N_q$ ,...., -1, -0, +0, +1, ...,+$N_q$}, A ={-$N_{q'}$ ,...., -1, -0, +0, +1, ..., + $N_{q'}$} in which the sign indicates the estimated bit value and the magnitude represents its reliability; and the method further comprises:

• computation (29) of sign-preserving factors by each variable node, for each iteration *I*, for each connected constraint node $c_m$, as a sum of a ponderated sign of the LLR $I_n$ and a sum of the signs of all messages, except for the message coming from $c_m$, received from the connected constraint nodes at iteration *I*:

$$\mu_{v_n \to c_m}^{(\ell)} = \xi \times sign\,(I_n) + \sum_{c \in V(v_n) \setminus \{c_m\}} sign\left(m_{c \to v_n}^{(\ell)}\right)$$ where $\xi$ is a positive or a null integer, and of messages to connected constraint nodes $c_m$ for iteration *I* +1 in two steps

•

$$m_{v_n \to c_m}^{(\ell+1),U} = I_n + \frac{1}{2} \times \mu_{v_n \to c_m}^{(\ell)} + \sum_{c \in V(v_n) \setminus \{c_m\}} \left(m_{c \to v_n}^{(\ell)}\right)$$

and

$$m_{v_n \to c_m}^{(\ell+1)} = \left(\,sign\left(m_{v_n \to c_m}^{(\ell+1),U}\right), \mathcal{S}\left(floor\left(abs\left(m_{v_n \to c_m}^{(\ell+1),U}\right)\right)\right)\right)$$

where S is a function from the set of values that can take $floor\left(abs\left(m_{v_n \to c_m}^{(\ell+1),U}\right)\right)$ to the alphabet $A_s$.

**10.** A computer readable medium encoding a machine-executable program of instructions which, when executed by a computer, cause the computer to carry out the method according to claim 9.


**Patentansprüche**

**1.** Iterativer Decodierer, der zum Decodieren eines Codeworts eines Codes konfiguriert ist, der durch einen Tanner-Graphen dargestellt wird und eine Codewortlänge N aufweist, der iterative Decodierer umfassend:

• N variable Knoten (VNs) $v_n$, n = 1... N, wobei jeder variable Knoten $v_n$ konfiguriert ist, um ein Log-Likelihood-Verhältnis LLR $I_n$ eines kanaldecodierten Bits n des zu decodierenden Codeworts zu empfangen, wobei das LLR $I_n$ auf einem Alphabet $A_L$ von $q_{ch}$ Quantisierungsbits definiert ist, wobei $q_{ch}$ eine ganze Zahl gleich oder größer als 2 ist;
• M Einschränkungsknoten (CNs) $C_m$, m = 1 ...M, $2 \leq M < N$;
• wobei die variablen Knoten und die Einschränkungsknoten Knoten des Tanner-Graphen darstellen, wobei die variablen Knoten und die Einschränkungsknoten konfiguriert sind, um Nachrichten entlang Kanten des Tanner-Graphen auszutauschen;
• wobei jeder variable Knoten $v_n$ konfiguriert ist zum Schätzen eines A-posteriori-Wahrscheinlichkeit-Werts, APP-Werts, des $n^{ten}$ Bits des zu decodierenden Codeworts und zum Senden von Nachrichten $m_{Vn \to Cm}$, die zu einem Alphabet $A_s$ von q Quantisierungsbits gehören, wobei $q \leq q_{ch}$, an die verbundenen Einschränkungsknoten $c_m$, wobei ein Satz verbundener Einschränkungsknoten mit $V_{(vn)}$ bezeichnet wird, ein Grad $d_v$ des variablen Knotens $v_n$ als die Größe des Satzes $V_{(vn)}$ definiert ist und der Satz $V_{(vn)}$ mit Ausnahme des Einschränkungsknotens $c_m$ mit $V_{(vn)\setminus\{cm\}}$ bezeichnet wird,
• wobei jeder Einschränkungsknoten $c_m$ zum Testen der empfangenen Nachricht mit vorbestimmten Einschränkungen und Senden von Nachrichten $m_{Cm \to Vn}$, wobei Nachrichten, die zu einem Alphabet $A_c$ von q' Quantisierungsbits gehören, einen unterschiedlichen oder ähnlichen Satz von Werten aufweisen als $A_s$, an die verbundenen variablen Knoten $v_n$ konfiguriert ist;
• wobei die Nachrichtenemissionen wiederholt werden, bis das Decodieren des Codeworts erfolgreich erreicht wird oder eine vorbestimmte Anzahl von Iterationen erreicht wird; **dadurch gekennzeichnet, dass**
• das LLR $I_n$ und die Nachrichten $m_{Vn \to Cm}$ und $m_{Cm \to Vn}$ gemäß einem Vorzeichen- und Größencode in den Alphabeten $A_L$, $A_s$ und $A_c$ symmetrisch um Null codiert werden, $A_L$= {-$N_{qch}$,..., -1, -0, +0, +1, ...,+$N_{qch}$}, $A_S$= {-$N_q$,..., -1, - 0, +0, +1, ...,+$N_q$} $A_C$= {-$N_{q'}$,..., -1, -0, +0, +1, ...,+$N_{q'}$}, wobei das Vorzeichen den geschätzten Bitwert angibt und die Größe seine Zuverlässigkeit darstellt; und

• jeder variable Knoten $v_n$, für jede Iteration $l$, konfiguriert ist zum Berechnen von:
• vorzeichenerhaltenden Faktoren für jeden verbundenen Einschränkungsknoten $c_m$ als eine Summe eines gewogenen Vorzeichens des LLR $I_n$ und eine Summe der Vorzeichen aller Nachrichten, mit Ausnahme der Nachricht, die von $c_m$ stammt, die von den verbundenen Einschränkungsknoten bei Iteration $l$ empfangen wird:

$$\mu_{v_n \to c_m}^{(\ell)} = \xi \times sign\,(I_n) + \textstyle\sum_{c \in V(v_n) \backslash \{c_m\}} \; sign\left(m_{c \to v_n}^{(\ell)}\right)$$

wobei $\xi$ eine positive ganze Zahl oder eine ganze Zahl von Null ist, und
• Nachrichten an verbundene Einschränkungsknoten $c_m$ für die Iteration $l$ +1 in zwei Schritten:

$$m_{v_n \to c_m}^{(\ell+1),U} = I_n + \tfrac{1}{2} \times \mu_{v_n \to c_m}^{(\ell)} + \textstyle\sum_{c \in V(v_n) \backslash \{c_m\}} \left(m_{c \to v_n}^{(\ell)}\right)$$

und

$$m_{v_n \to c_m}^{(\ell+1)} = \left(\, sign\!\left(m_{v_n \to c_m}^{(\ell+1),U}\right), \mathcal{S}\left(floor\left(abs\!\left(m_{v_n \to c_m}^{(\ell+1),U}\right)\right)\right)\right)$$

wobei S eine Funktion aus dem Satz von Werten ist, die floor $\left(abs\!\left(m_{v_n \to c_m}^{(\ell+1),U}\right)\right)$ in das Alphabet $A_S$ übernehmen kann.

2. Iterativer Decodierer nach Anspruch 1, wobei $\xi$ gleich 0, falls $d_v$ = 2, gleich 1, falls $d_v$ > 2 und $d_v$ ungerade ist, und gleich 2 ist, wenn $d_v$ > 2 und $d_v$ gerade ist.

3. Iterativer Decodierer nach Anspruch 1 oder 2, wobei die Einschränkungsknoten Paritätsprüfung, einen Faltungscode oder einen beliebigen Blockcode als Einschränkungen verwenden.

4. Iterativer Decodierer nach Anspruch 3, wobei das Codewort durch LDPC codiert ist und die Einschränkungsknoten Prüfknoten sind.

5. Iterativer Decodierer nach einem der vorstehenden Ansprüche, wobei die Funktion S als S(x) = min(max(x - λ(x), 0),+Nq) definiert ist, wobei λ (x) ein ganzzahliger Versatzwert ist, abhängig von dem Wert von x.

6. Iterativer Decodierer nach Anspruch 5, wobei λ(x) eine zufällige Variable ist, die seinen Wert in einem vordefinierten Satz von Werten gemäß einem vordefinierten Gesetz annehmen kann.

7. Iterativer Decodierer nach einem der vorstehenden Ansprüche, wobei die Alphabete $A_s$ und $A_c$ identisch sind.

8. Iterativer Decodierer nach einem der vorstehenden Ansprüche, wobei das Mittel umfasst

• mindestens einen Prozessor; und
• mindestens einen Speicher, der Computerprogrammcode einschließt, wobei der mindestens eine Speicher und der Computerprogrammcode konfiguriert sind, um, mit dem mindestens einen Prozessor, die Leistung des Decodierers zu bewirken.

9. Iteratives Decodierverfahren zum Decodieren eines Codeworts eines Codes, der durch einen Tanner-Graphen dargestellt wird und eine Codewortlänge N aufweist, durch einen iterativen Decodierer nach einem der Ansprüche 1 bis 8, der iterative Decodierer umfassend N variable Knoten (VNs) $v_n$, n = 1... N, und M Einschränkungsknoten (CNs) $c_m$, m = 1 ...M, 2 ≤ M < N, wobei die Variable und Einschränkungsknoten Knoten des Tanner-Graphen darstellen, das Verfahren umfassend die folgenden Schritte:

• Empfang und Speicherung (21) eines Log-Likelihood-Verhältnisses LLR $I_n$ eines kanaldecodierten Bits n des Codeworts, das durch den variablen Knoten vn, n = 1...N, decodiert werden soll, wobei das LLR $I_n$ auf einem

Alphabet $A_L$ von $q_{ch}$ Quantisierungsbits definiert ist, wobei $q_{ch}$ eine ganze Zahl gleich oder größer als 2 ist;

• Schätzung durch jeden variablen Knoten $v_n$ eines A-posteriori-Wahrscheinlichkeit-Werts, APP-Werts, des $n^{ten}$ Bits des zu decodierenden Codeworts,

• Emission (23) von Nachrichten $m_{Vn \to Cm}$ von jedem variablen Knoten $v_n$ an die verbundenen Einschränkungsknoten $c_m$, wobei die Nachrichten zu einem Alphabet $A_s$ von q Quantisierungsbits, $q \leq q_{ch}$, gehören, wobei ein Satz verbundener Einschränkungsknoten mit $V_{(vn)}$ bezeichnet wird, ein Grad $d_v$ des variablen Knotens $v_n$ als die Größe des Satzes $V_{(vn)}$ definiert ist und der Satz $V_{(vn)}$ mit Ausnahme des Einschränkungsknotens $c_m$ mit $V_{(vn)\backslash\{cm\}}$ bezeichnet wird,

• Empfang der Nachrichten und Verifizierung (25) der empfangenen Nachrichten mit vorbestimmten Einschränkungen durch die Einschränkungsknoten $c_m$:

• Emission (27) von Nachrichten $m_{Cm \to Vn}$, die einen möglichen Kandidatenwert für eine Variable n enthalten, die die Einschränkungen lösen, an die verbundenen variablen Knoten $v_n$ lösen, wobei die Nachrichten zu einem Alphabet $A_c$ von q' Quantisierungsbits gehören;

◦ Wiederholung der Nachrichtenemissionen, bis das Decodieren des Codeworts erfolgreich erreicht wird oder eine vorbestimmte Anzahl von Iterationen erreicht wird;

**dadurch gekennzeichnet, dass**

◦ das LLR $l_n$ und die Nachrichten $m_{Vn \to Cm}$ und $m_{Cm \to Vn}$ gemäß einem Vorzeichen- und Größencode in den Alphabeten $A_L$, $A_s$ und $A_c$ symmetrisch um Null codiert werden, $A_L = \{-N_{qch},..., -1, -0, +0, +1, ...,+N_{qch}\}$, $A_S = \{-N_q,..., -1, - 0, +0, +1, ...,+N_q\}$, $A_C = \{-N_{q'},..., -1, -0, +0, +1, ...,+N_{q'}\}$, wobei das Vorzeichen den geschätzten Bitwert angibt und die Größe seine Zuverlässigkeit darstellt; und das Verfahren ferner umfasst:

• Berechnung (29) von vorzeichenerhaltenden Faktoren durch jeden variablen Knoten für jede Iteration $l$, für jeden verbundenen Einschränkungsknoten $c_m$, als eine Summe eines gewogenen Vorzeichens des LLR $l_n$ und eine Summe der Vorzeichen aller Nachrichten, mit Ausnahme der Nachricht, die von $c_m$ stammt, die von den verbundenen Einschränkungsknoten bei Iteration 1 empfangen wird:

$$\mu_{v_n \to c_m}^{(\ell)} = \xi \times sign(l_n) + \sum_{c \in V(v_n)\backslash\{c_m\}} sign\left(m_{c \to v_n}^{(\ell)}\right)$$

wobei $\xi$ eine positive ganze Zahl oder eine ganze Zahl von Null ist, und von Nachrichten an verbundene Einschränkungsknoten $c_m$ für die Iteration $l$ +1 in zwei Schritten:

•

$$m_{v_n \to c_m}^{(\ell+1),U} = l_n + \frac{1}{2} \times \mu_{v_n \to c_m}^{(\ell)} + \sum_{c \in V(v_n)\backslash\{c_m\}} \left(m_{c \to v_n}^{(\ell)}\right)$$

und

$$m_{v_n \to c_m}^{(\ell+1)} = \left( sign\left(m_{v_n \to c_m}^{(\ell+1),U}\right), \mathcal{S}\left(floor\left(abs\left(m_{v_n \to c_m}^{(\ell+1),U}\right)\right)\right)\right)$$

wobei S eine Funktion aus dem Satz von Werten ist, die $floor\left(abs\left(m_{v_n \to c_m}^{(\ell+1),U}\right)\right)$ in das Alphabet $A_S$ übernehmen kann.

**10.** Computerlesbares Medium, das ein maschinenausführbares Programm von Anweisungen codiert, die, wenn sie durch einen Computer ausgeführt werden, den Computer veranlassen, das Verfahren nach Anspruch 9 durchzuführen.

**Revendications**

**1.** Décodeur itératif configuré pour décoder un mot de code d'un code représenté par un graphe de Tanner et ayant une longueur de mot de code N, ledit décodeur itératif comprenant :

• N noeuds variables (VNs) $v_n$, n = 1... N, chaque noeud variable $v_n$ étant configuré pour recevoir un rapport de vraisemblance logarithmique LLR $l_n$ d'un bit décodé de canal n du mot de code à décoder, ledit LLR $l_n$ étant défini sur un alphabet $A_L$ de $q_{ch}$ bits de quantification, $q_{ch}$ étant un nombre entier égal ou supérieur à 2 ;
• M noeuds de contrainte (CNs) $C_m$, m = 1...M, $2 \leq M < N$ ;
• les noeuds variables et les noeuds de contrainte représentant des noeuds du graphe de Tanner où les noeuds variables et les noeuds de contraintes sont configurés pour échanger des messages le long des bords du graphe de Tanner ;
• chaque noeud variable $v_n$ étant configuré pour estimer une valeur de probabilité a posteriori, APP, du nème bit du mot de code à décoder et pour envoyer des messages $m_{vn \to cm}$ appartenant à un alphabet $A_s$ de q bits de quantification, $q \leq q_{ch}$, aux noeuds de contrainte connectés $c_m$, où un ensemble de noeuds de contrainte connectés est noté $V_{(vn)}$, un degré $d_v$ du noeud variable $v_n$ est défini comme la taille de l'ensemble $V_{(vn)}$, et l'ensemble $V_{(vn)}$ à l'exception du noeud de contrainte $c_m$ est noté $V_{(vn) \backslash \{cm\}}$,
• chaque noeud de contrainte $c_m$ étant configuré pour tester le message reçu avec des contraintes prédéterminées et pour envoyer des messages $m_{Cm \to Vn}$, messages appartenant à un alphabet $A_c$ de q' bits de quantification, ayant un ensemble de valeurs différent ou similaire à $A_s$, aux noeuds variables connectés $v_n$ ;
• les émissions de messages étant répétées jusqu'à ce que le décodage du mot de code soit obtenu avec succès ou qu'un nombre prédéterminé d'itérations soit atteint ; **caractérisé en ce que**
• les LLR $l_n$ et les messages $m_{Vn \to Cm}$ et $m_{Cm \to Vn}$ sont codés selon un code de signe et de grandeur dans les alphabets $A_L$, $A_s$ et $A_c$ symétrique autour de zéro, $A_L$ = {-$N_{qch}$,..., -1, -0, +0, +1,.., +$N_{qch}$}, As= {-$N_q$,..., -1, -0, +0, +1, .., +$N_q$}, $A_C$ = {-$N_{q'}$,..., -1, -0, +0, +1,.., +$N_q$} dans lequel le signe indique la valeur de bit estimée et la grandeur représente sa fiabilité ; et
• chaque noeud variable $v_n$, pour chaque itération $l$, est configuré pour calculer :

• les facteurs de préservation de signe, pour chaque noeud de contrainte connecté $c_m$ en tant que somme de signe pondéré du LLR $l_n$ et une somme des signes de tous les messages, sauf pour le message provenant de $c_m$, reçu des noeuds de contrainte connectés à l'itération 1 :

$$\mu_{v_n \to c_m}^{(\ell)} = \xi \times sign(l_n) + \sum_{c \in V(v_n) \backslash \{c_m\}} sign\left(m_{c \to v_n}^{(\ell)}\right)$$

où $\xi$ est un entier positif ou nul, et
• les messages à des noeuds de contrainte connectés $c_m$ pour l'itération 1 +1 en deux étapes :

$$m_{v_n \to c_m}^{(\ell+1),U} = l_n + \frac{1}{2} \times \mu_{v_n \to c_m}^{(\ell)} + \sum_{c \in V(v_n) \backslash \{c_m\}}\left(m_{c \to v_n}^{(\ell)}\right)$$

et

$$m_{v_n \to c_m}^{(\ell+1)} = \left(sign\left(m_{v_n \to c_m}^{(\ell+1),U}\right), \mathcal{S}\left(floor\left(abs\left(m_{v_n \to c_m}^{(\ell+1),U}\right)\right)\right)\right)$$

où S est une fonction de l'ensemble de valeurs qui peuvent prendre plancher $\left(abs\left(m_{v_n \to c_m}^{(\ell+1),U}\right)\right)$ à l'alphabet $A_s$.

2. Décodeur itératif selon la revendication 1, dans lequel $\xi$ est égal à 0 si $d_v$ = 2, égal à 1 si $d_v$ > 2 et $d_v$ est impair, et égal à 2 si $d_v$ >2 et $d_v$ est pair.

3. Décodeur itératif selon la revendication 1 ou 2, dans lequel les noeuds de contrainte utilisent un contrôle de parité, un code de convolution ou tout code de bloc en tant que contraintes.

4. Décodeur itératif selon la revendication 3, dans lequel le mot de code est codé par LDPC et les noeuds de contrainte sont des noeuds de contrôle.

5. Décodeur itératif selon l'une quelconque revendication précédente, dans lequel la fonction S est définie comme S(x) = min(max(x - λ(x), 0), +Nq), où λ (x) est une valeur de décalage entière en fonction de la valeur de x.

6. Décodeur itératif selon la revendication 5, dans lequel λ(x) est une variable aléatoire qui peut prendre sa valeur dans un ensemble prédéfini de valeurs selon une loi prédéfinie.

7. Décodeur itératif selon l'une quelconque revendication précédente, dans lequel les alphabets $A_s$ et $A_c$ sont identiques.

8. Décodeur itératif selon l'une quelconque revendication précédente dans lequel le moyen comprend

   • au moins un processeur ; et
   • au moins une mémoire comportant un code de programme informatique, l'au moins une mémoire et le code de programme informatique étant configurés pour, avec l'au moins un processeur, entraîner l'exécution du décodeur.

9. Procédé de décodage itératif pour décoder un mot de code d'un code représenté par un graphe de Tanner et ayant une longueur de mot de code N, par un décodeur itératif selon l'une quelconque des revendications 1 à 8, le décodeur itératif comprenant N noeuds variables (VNs) $v_n$, n = 1 ... N, et M noeuds de contrainte (CNs) $c_m$, m = 1 ... M, $2 \leq M < N$, lesdits noeuds variables et de contrainte représentant des noeuds du graphe de Tanner, ledit procédé comprenant les étapes suivantes de :

   • réception et stockage (21) d'un rapport de vraisemblance logarithmique LLR $l_n$ d'un bit décodé de canal n du mot de code à décoder par le noeud variable $v_n$, n = 1 ... N, ledit LLR $l_n$ étant défini sur un alphabet $A_L$ de $q_{ch}$ bits de quantification, $q_{ch}$ étant un nombre entier égal ou supérieur à 2 ;
   • estimation par chaque noeud variable $v_n$ d'une valeur de probabilité a posteriori, APP, du $n^{ème}$ bit du mot de code à décoder,
   • émission (23) de messages $m_{vn \to cm}$ à partir de chaque noeud variable $v_n$ aux noeuds de contrainte connectés $c_m$, lesdits messages appartenant à un alphabet As de q bits de quantification, $q \leq q_{ch}$, où un ensemble de noeuds de contrainte connectés est noté $V_{(vn)}$, un degré $d_v$ du noeud variable $v_n$ est défini comme la taille de l'ensemble $V_{(vn)}$ et l'ensemble $V_{(vn)}$ à l'exception du noeud de contrainte $c_m$ est noté $V_{(vn)\backslash\{cm\}}$,
   • réception des messages et vérification (25) des messages reçus avec des contraintes prédéterminées par les noeuds de contrainte $c_m$ :
   • émission (27) de messages $m_{Cm \to Vn}$ contenant une valeur candidate possible pour une variable n résolvant les contraintes aux noeuds variables connectés $v_n$, lesdits messages appartenant à un alphabet $A_c$ de q' bits de quantification ;

      ◦ répétition des émissions de messages jusqu'à ce que le décodage du mot de code soit obtenu avec succès ou qu'un nombre prédéterminé d'itérations soit atteint ;

   **caractérisé en ce que**

      ◦ le LLR $l_n$ et les messages $m_{Vn \to Cm}$ et $m_{Cm \to Vn}$ sont codés selon un code de signe et de grandeur dans les alphabets $A_L$, $A_s$ et $A_c$ symétriques autour de zéro, $A_L = \{-N_{qch},..., -1, -0, +0, +1, ...,+N_{qch}\}$, $A_S = \{-N_q,..., -1, -0, +0, +1, ...,+N_q\}$, $A_C = \{-N_{q'},..., -1, -0, +0, +1, ...,+N_{q'}\}$ dans lequel le signe indique la valeur estimée du bit et la grandeur représente sa fiabilité ; et le procédé comprend en outre :

   • le calcul (29) de facteurs de préservation de signe par chaque noeud variable, pour chaque itération 1, pour chaque noeud de contrainte connecté $c_m$, comme une somme de signe pondéré du LLR $l_n$ et une somme des signes de tous les messages, sauf pour le message provenant de $c_m$, reçu des noeuds de contrainte connectés à l'itération 1 : $\mu_{v_n \to c_m}^{(\ell)} = \xi \times sign(l_n) + \sum_{c \in V(v_n)\backslash\{c_m\}} sign\left(m_{c \to v_n}^{(\ell)}\right)$ où $\xi$ est un entier positif ou nul, et de messages à des noeuds de contrainte connectés $c_m$ pour l'itération 1 +1 en deux étapes :

   •

   $$m_{v_n \to c_m}^{(\ell+1),U} = l_n + \frac{1}{2} \times \mu_{v_n \to c_m}^{(\ell)} + \sum_{c \in V(v_n)\backslash\{c_m\}} \left(m_{c \to v_n}^{(\ell)}\right)$$

et

$$m_{v_n \to c_m}^{(\ell+1)} = \left( \text{sign}\left(m_{v_n \to c_m}^{(\ell+1),U}\right), \mathcal{S}\left(\text{floor}\left(\text{abs}\left(m_{v_n \to c_m}^{(\ell+1),U}\right)\right)\right)\right)$$

où S est une fonction de l'ensemble de valeurs qui peuvent prendre plancher $\left(\text{abs}\left(m_{v_n \to c_m}^{(\ell+1),U}\right)\right)$ à l'alphabet $A_S$

10. Support lisible par ordinateur codant un programme d'instructions exécutables par une machine qui, lorsqu'il est exécuté par un ordinateur, permet à l'ordinateur de mettre en oeuvre le procédé selon la revendication 9.

Figure 1

Figure 2

Figure 3

Figure 4

**Figure 5**

**Figure 6**

Figure 7

Figure 8

Figure 9

Figure 10

Figure 11

Figure 12

Figure 13

Figure 14